(19)

Europäisches
Patentamt
European
Patent Office
Office européen
des brevets

(11) **EP 2 833 422 A1**

(12) **EUROPEAN PATENT APPLICATION**
published in accordance with Art. 153(4) EPC

(43) Date of publication:
**04.02.2015 Bulletin 2015/06**

(21) Application number: **13768008.8**

(22) Date of filing: **29.03.2013**

(51) Int Cl.:
*H01L 33/50* (2010.01)     *F21V 9/08* (2006.01)
*F21Y 101/02* (2006.01)

(86) International application number:
**PCT/JP2013/059611**

(87) International publication number:
**WO 2013/147195 (03.10.2013 Gazette 2013/40)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **30.03.2012   JP 2012080262**

(71) Applicant: **Mitsubishi Chemical Corporation
Chiyoda-ku
Tokyo 100-8251 (JP)**

(72) Inventors:
• **SAKUTA, Hiroaki
  Kanagawa 250-0862 (JP)**
• **KOHARA, Yuki
  Chiyoda-ku,
  Tokyo 100-8251 (JP)**

(74) Representative: **Vossius & Partner
Siebertstrasse 4
81675 München (DE)**

(54) **SEMICONDUCTOR LIGHT-EMITTING DEVICE, AND ILLUMINATION DEVICE**

(57)     The problem to be solved is to provide a semiconductor light emitting device attaining the improvement of the color rendering property in addition to the improvement of the light emission efficiency.

The semiconductor light emitting device of the present invention including a cut filter configured to absorb light having a short wavelength equal to or less than 430 nm and transmit light having a long wavelength greater than 430 nm, wherein in a spectrum of the light emitted by the semiconductor light emitting device, light emission peak intensity deriving from the emitted light of the semiconductor light emitting element with respect to maximum intensity of the spectrum is equal to or lower than 50%. The above-mentioned problem is solved by using the semiconductor light emitting device.

Fig. 1

**Description**

TECHNICAL FIELD

The present invention relates to a semiconductor light emitting device and, more particularly, to a semiconductor light emitting device having high light emission efficiency and an improved color rendering property. Further, the present invention relates to an illumination device including the semiconductor light emitting device.

BACKGROUND ART

A light emitting device including a semiconductor light emitting element is increasing its presence as an energy-saving light emitting device. On the other hand, various techniques for further improvement of light emission efficiency have been proposed for the light emitting device including the semiconductor light emitting element.
For example, in order to improve the light emission efficiency, there is proposed an illumination device including, in an opening section of a package, a cut filter configured to reflect light other than visible light (see Patent Document 1). This technique is intended to be applied to a backlight for a liquid crystal display and considered to realize a device with high light emission efficiency.
In a light emitting device including a phosphor layer, there is proposed a technique for controlling a particle size distribution and a filling ratio of phosphor particles to obtain a dense phosphor layer and improve light emission efficiency (see Patent Document 2).
On the other hand, since an ultraviolet ray is generated in an illumination light source such as a fluorescent lamp, an ultraviolet ray absorption filter is attached to a fluorescent tube or the like (Patent Document 3).

Citation List

Patent Document

[Patent Document 1] Japanese Patent Application Laid-open No. 2007-88348
[Patent Document 2] Japanese Patent Application Laid-open No. 2011-228673
[Patent Document 3] Japanese Patent No. 3118226

SUMMARY OF INVENTION

TECHNICAL PROBLEM

Application of the light emitting device including the semiconductor light emitting device to general lighting has been examined and realized. In the application to the general lighting, not only the improvement of the light emission efficiency from the viewpoint of energy saving but also a preferable color rendering property of the light emitting device has to be attained.
It is an object of the present invention to attain the improvement of the color rendering property requested in such application to the general lighting in addition to the improvement of the light emission efficiency.
The inventors earnestly conducted researches in order to attain the object, found that it is possible to attain both of the improvement of the light emission efficiency and the improvement of the color rendering property by providing a cut filter configured to absorb light having a short wavelength equal to or less than 430 nm and transmit light having a long wavelength greater than 430 nm to adjust a light emission spectrum of light emitted by the semiconductor light emitting device to satisfy a fixed condition, and completed the present invention.
According to an aspect of the present invention, there is provided a semiconductor light emitting device including: a semiconductor light emitting element configured to emit light having a light emission peak at a wavelength 390 nm or more and 430 nm or less; and a wavelength conversion layer including a phosphor configured to emit light using, as an excitation source, the light emitted by the semiconductor light emitting element,
the semiconductor light emitting device including a cut filter configured to absorb light having a short wavelength equal to or less than 430 nm and transmit light having a long wavelength greater than 430 nm, and emitting light through the cut filter.
It is preferable that, in a spectrum of the light emitted by the semiconductor light emitting device, light emission peak intensity deriving from the emitted light of the semiconductor light emitting element with respect to maximum intensity of the spectrum is equal to or lower than 50%.

According to a second aspect of the present invention, there is provided a semiconductor light emitting device including: a semiconductor light emitting element configured to emit light having a light emission peak at a wavelength 390 nm or more and 430 nm or less; and a wavelength conversion layer including a phosphor configured to emit light using, as an excitation source, the light emitted by the semiconductor light emitting element,

the semiconductor light emitting device including a cut filter configured to absorb light having a short wavelength equal to or less than 430 nm and transmit light having a long wavelength greater than 430 nm and emitting light through the cut filter, wherein

the wavelength conversion layer contains at least one narrowband phosphor among phosphors of a group of a narrowband red phosphor, a narrowband green phosphor, and a narrowband blue phosphor, and

in a spectrum of the light emitted by the semiconductor light emitting device, light emission peak intensity deriving from the emitted light of the semiconductor light emitting element with respect to maximum intensity of the spectrum is equal to or lower than 20%.

It is preferable that the wavelength conversion layer is a light transmission type wavelength conversion layer, and the cut filter is arranged on an emission side of light of the wavelength conversion layer.

On the other hand, it is also preferable that the semiconductor light emitting device includes a housing including an opening section capable of emitting light and a reflecting section configured to reflect light,

the cut filter is arranged in the opening section of the housing, and

the wavelength conversion layer is a light reflection type wavelength conversion layer arranged in the reflecting section of the housing to reflect light emitted from the semiconductor light emitting element.

It is preferable that the cut filter absorbs 50% or more of light having a wavelength equal to or less than 430 nm.

It is preferable that, when an incident angle θ is changed to an arbitrary angle in a range of 0 to 180°, fluctuation Δtθ of transmittance tθ of light made incident on a cut filter surface at the incident angle 0 is equal to or lower than 50%.

It is preferable that the semiconductor light emitting device includes a transparent substrate, and the cut filter is supported by the transparent substrate.

It is preferable that a surface of the transparent substrate on a side opposed to the cut filter is subjected to non-reflection treatment.

It is preferable that a light emission peak wavelength of light emitted from the semiconductor light emitting element and reaching the cut filter without being subjected to wavelength conversion by the wavelength conversion layer is 50% or more and 250% or less of light emission intensity of light at a maximum light emission peak of visible light emitted from the semiconductor light emitting device.

It is preferable that the semiconductor light emitting element and the wavelength conversion layer are arranged to have a distance 1 mm or more and 500 mm or less. On the other hand, it is preferable that the semiconductor light emitting element and the wavelength conversion layer are arranged in contact with each other.

It is preferable that the semiconductor light emitting device emits white light having a correlated color temperature 1800 K or more and 7500 K or less. It is preferable that an average color rendering index Ra is equal to or higher than 70.

It is preferable that an illumination device includes the semiconductor light emitting device.

ADVANTAGEROUS EFFECTS OF INVENTION

According to the first aspect and the second aspect of the present invention, it is possible to provide the semiconductor light emitting device that realizes improvement of a color rendering property in addition to improvement of light emission efficiency. According to the present invention, it is possible to provide an illumination light source that emits light having a high color rendering property. It is unnecessary to arrange a cut filter or the like on the outer side of a light source, for example, in a lens to adjust a spectrum. Therefore, it is possible to provide thin lighting.

Brief Description of the Drawings

Fig. 1 is a conceptual diagram showing an embodiment of a semiconductor light emitting device in which a wavelength conversion layer is a light transmission type wavelength conversion layer among semiconductor light emitting devices including cut filters of the present invention.
Fig. 2 is a conceptual diagram showing an embodiment of a semiconductor light emitting device in which a wavelength conversion layer is a light transmission type wavelength conversion layer among semiconductor light emitting devices including cut filters of the present invention.
Fig. 3 is a conceptual diagram showing an embodiment of a semiconductor light emitting device in which a wavelength conversion layer is a light transmission type wavelength conversion layer among semiconductor light emitting devices including cut filters of the present invention.

Fig. 4 is a conceptual diagram showing an embodiment of a semiconductor light emitting device in which a wavelength conversion layer is a light transmission type wavelength conversion layer among semiconductor light emitting devices including cut filters of the present invention.

Fig. 5 is a conceptual diagram showing an embodiment of a semiconductor light emitting device in which a wavelength conversion layer is a light transmission type wavelength conversion layer among semiconductor light emitting devices including cut filters of the present invention.

Fig. 6 is a conceptual diagram showing an embodiment of a semiconductor light emitting device in which a wavelength conversion layer is a light transmission type wavelength conversion layer among semiconductor light emitting devices including cut filters of the present invention.

Fig. 7 is a conceptual diagram showing an embodiment of a semiconductor light emitting device in which a wavelength conversion layer is a light transmission type wavelength conversion layer among semiconductor light emitting devices including cut filters of the present invention.

Fig. 8 is a conceptual diagram showing an embodiment of a semiconductor light emitting device in which a wavelength conversion layer is a light transmission type wavelength conversion layer among semiconductor light emitting devices including cut filters of the present invention.

Fig. 9 is a conceptual diagram showing an embodiment of a semiconductor light emitting device in which a wavelength conversion layer is a light transmission type wavelength conversion layer among semiconductor light emitting devices including cut filters of the present invention.

Fig. 10 is a graph showing spectra of lights emitted from light emitting devices in an experiment 3.

Fig. 11 is a graph showing spectra of lights emitted from light emitting devices in a comparative example 1 and a reference example 4.

Fig. 12 is a graph showing spectra of lights emitted from light emitting devices in a comparative example 2 and a reference example 5.

Modes for Carrying Out the Invention

A semiconductor light emitting device of the present invention is a semiconductor light emitting device including a semiconductor light emitting element, a wavelength conversion layer, and a cut filter. The semiconductor light emitting device of the present invention is a semiconductor light emitting device having high light emission efficiency and a high color rendering property and is preferably applied to general lighting. Therefore, light emitted by the semiconductor light emitting device of the present invention is white light. A color temperature is preferably 1800 K or more and 7500 K or less and more preferably 2000 K or more and 7000 K or less. A deviation duv from a blackbody radiation locus of a light color of the white light is preferably -0.0200 to 0.0200.

The present invention will be explained below with reference to embodiments and examples. However, it is to be noted that the present invention is by no means restricted to the following embodiments, examples and the like and any modifications can be added thereto insofar as they do not depart from the spirit and scope of the present invention.

Further, numerical range represented using "from ... to" in the present Specification means a range including the numerical values described after "from" and after "to" as a lower limit and an upper limit, respectively. Moreover, all the relationships between colors and their color coordinates in the present Specification comply with the Japanese Industrial Standards (JIS Z8110).

Each composition formula of the phosphors in this Specification is punctuated by a comma (,). Further, when two or more elements are juxtaposed with a comma (,) in between, one kind of or two or more kinds of the juxtaposed elements can be contained in the composition formula in any combination and in any composition.

<1. Semiconductor light emitting element>

A semiconductor light emitting element included in a semiconductor light emitting device of the present invention emits light having a light emission peak in a wavelength region equal to or less than 430 nm. Examples of such a semiconductor light emitting element include a violet semiconductor light emitting element that emits light in a violet region, a near ultraviolet semiconductor light emitting element that emits light in a near ultraviolet region, and an ultraviolet semiconductor light emitting element that emits light in an ultraviolet region.

The semiconductor light emitting element which emits light in a purple color region is a semiconductor light emitting element having a light emission peak in a wavelength range of 390 nm or more and 430 nm or less. The semiconductor light emitting element which emits near ultraviolet light is a semiconductor light emitting element having a light emission peak in a wavelength region equal to or greater than 320 nm and less than 390 nm. The semiconductor light emitting element which emits ultraviolet light is a semiconductor light emitting element having a light emission peak in a wavelength region equal to or greater than 10 nm and less than 320 nm.

In the present invention, it is preferable to use the semiconductor light emitting element that emits light in the violet region, that is, has a light emission peak in a wavelength range of 390 nm or more and 430 nm or less because light emission efficiency of the semiconductor light emitting element is high and a quantum loss of a phosphor is small.

It is preferable that the semiconductor light emitting element is a light emitting diode (LED) or a laser diode (LD) capable of emitting light in the range and, above all, a GaN-based LED or LD in which a light emitting structure is configured using a GaN-based semiconductor such as GaN, AlGaN, GaInN, or AlGaInN. An LED or an LD in which a light emitting structure is configured by a ZnO-based semiconductor besides the GaN-based semiconductor is preferable. As the GaN-based LED, an LED including a light emitting section formed by a GaN-based semiconductor containing In, in a light emitting section, a quantum well structure including an InGaN layer is particularly preferable because light emission intensity is extremely high.

<2. Wavelength conversion layer>

A wavelength conversion layer included in the semiconductor light emitting device of the present invention includes a phosphor configured to emit light using, as an excitation source, light emitted by the semiconductor light emitting element.

The wavelength conversion layer included in the semiconductor light emitting device of the present invention may contain only one kind of a phosphor or may contain a plurality of kinds of phosphors.

As the wavelength conversion layer containing only the one kind of a phosphor, a form can be illustrated in which a wavelength conversion layer including an orange phosphor is combined with a semiconductor light emitting element that emits light in a violet region.

Examples of the wavelength conversion layer containing the plurality of kinds of phosphors include the following forms:

(i) a wavelength conversion layer including a mixture obtained by mixing a red phosphor, a green phosphor, and a blue phosphor; and
(ii) a wavelength conversion layer including a mixture obtained by mixing a blue phosphor and a yellow phosphor.

Note that phosphors of other colors may be contained in the forms as appropriate.

In the wavelength conversion layer included in the semiconductor light emitting device of the present invention, it is preferable that, in improving light emission efficiency, a ratio of light directly transmitted without being subjected to wavelength conversion in excitation light from the semiconductor light emitting element (hereinafter also referred to as excitation light transmittance) is high to some degree. It is preferable that the wavelength conversion layer is thin.

The wavelength conversion layer provided to the semiconductor light emitting device of the present invention has an excitation light transmittance of preferably 50% or more and more preferably 70% or more. Meanwhile, the excitation light transmittance is preferably 250% or less and more preferably 200% or less. Light emission efficiency is improved when the wavelength conversion layer is within the range.

The excitation light transmittance of the wavelength conversion layer can be represented by a ratio $[(I_{LED}) / (I_p)] \times 100$ of peak wavelength intensity $(I_{LED})$ driving from the semiconductor light emitting element to peak wavelength intensity $(I_p)$ deriving from the phosphor at a wavelength of a spectrum of light emitted from the semiconductor light emitting device and transmitted through the wavelength conversion layer.

In order to form the wavelength conversion layer that satisfies the range of the excitation light transmittance, for example, the thickness of the wavelength conversion layer and a content of the phosphor in the wavelength conversion layer only have to be adjusted as appropriate. Specifically, depending on a type of the phosphor, a content of the phosphor particles is set to preferably 0.5 % by weight or more and more preferably 1.0 % by weight or more with respect to a total amount of the wavelength conversion layer including binder resin and the phosphor. The content of the phosphor particles is set to preferably 70% by weight or less, more preferably 50% by weight or less, even more preferably 30% by weight or less, and still more preferably 20% by weight or less. It is possible to adjust the excitation light transmittance by adjusting phosphor concentration as appropriate according to the wavelength conversion efficiency of the phosphor and the thickness of the phosphor layer within these ranges.

In addition, making the wavelength conversion layer thinner enables reduction of the self-absorption of the light among the phosphors and reduces the light scattering caused by the phosphors. In the present invention, preferably making the thickness of the wavelength conversion layer at least twice the volumetric basis median diameter of the phosphor contained in the wavelength conversion layer and not more than 10 times this diameter enables to reduce the self-absorption of the light of the phosphors and reduces the light scattering caused by the phosphors. The thickness of the wavelength conversion layer is more preferably three times or more the median diameter of the phosphor and particularly preferably four times or more the median diameter. The thickness of the wavelength conversion layer is preferably not more than nine times the median diameter of the phosphor, particularly preferably not more than eight times the median diameter, and more preferably not more than seven times the median diameter, and even more preferably not more than six times the median diameter, and most preferably not more than five times the median diameter. The thickness of the wavelength conversion layer can be measured by cutting the wavelength conversion layer in the thickness direction and observing the cross section using an electron microscope such as an SEM. Further, the combined thickness of the substrate coated with the wavelength conversion layer and the wavelength conversion layer is measured using a micrometer, and the thickness of the wavelength conversion layer can be measured by using a micrometer to measure the thickness of the substrate once again after the wavelength conversion layer has been detached from the substrate. Similarly, the thickness can be measured directly by partially detaching the wavelength conversion layer and using a stylus profile measuring system to measure the difference between the part where the wavelength conversion layer remains and the part from which the wavelength conversion layer has been detached.

<2-1. Phosphor>

The phosphor contained in the wavelength conversion layer is a phosphor configured to emit light using, as an excitation source, light emitted by the semiconductor light emitting element.

The types of phosphor used by the present invention may be suitably chosen but the following phosphor types are given as representative phosphors for red (orange), green, blue, and yellow phosphors.

<2-2. Red Phosphors>

It is preferable that the wavelength of emission peak of a red phosphor is in the range of usually 565 nm or longer, preferably 575 nm or longer, more preferably 580 nm or longer, and usually 780 nm or shorter, preferably 700 nm or shorter, more preferably 680 nm or shorter.

The half width of emission peak of such a red phosphor is usually in the range of 1 nm to 100 nm. External quantum efficiency is usually equal to or higher than 60% and preferably equal to or higher than 70%. A weight median diameter is usually equal to or larger than 0.1 $\mu$m, preferably equal to or larger than 1.0 $\mu$m, and more preferably equal to or larger than 5.0 $\mu$m and is usually equal to or smaller than 40 $\mu$m, preferably equal to or smaller than 30 $\mu$m, and more preferably equal to or smaller than 20 $\mu$m.

As such a red phosphor, it is also possible to use, for example, Eu activated oxide, nitride, or oxynitride phosphors such as $CaAlSiN_3$:Eu described in Japanese Patent Application Laid-open No. 2006-008721, $(Sr, Ca)AlSiN_3$:Eu described in Japanese Patent Application Laid-open No. 2008-7751, and $Ca_{1-x}Al_{1-x}Si_{1+x}N_{3-x}O_x$:Eu described in Japanese Patent Application Laid-open No. 2007-231245 and $(Sr, Ba, Ca)_3SiO_5$:Eu described in Japanese Patent Application Laid-open No. 2008-38081 (hereinafter sometimes abbreviated as "SBS phosphor").

Besides, as the red phosphor, it is also possible to use an Eu activated alkali earth silicon nitride phosphor such as $(Mg, Ca, Sr, Ba)_2Si_5N_8$:Eu, an Eu activated oxysulfide phosphor such as $(La, Y)_2O_2S$:Eu, an EU activated rare earth oxychalcogenide phosphor such as $(Y, La, Gd, Lu)_2O_2S$:Eu, Eu activated oxide phosphors such as $Y(V, P)O_4$; Eu and $Y_2O_3$:Eu, Eu, Mn activated silicate phosphors such as $(Ba, Mg)_2SiO_4$:Eu, Mn and $(Ba, Sr, Ca, Mg)_2SiO_4$:Eu, Mn, Eu activated tungstate phosphors such as $LiW_2O_8$: Eu, $LiW_2O_8$:Eu, Sm, $Eu_2W_2O_9$, $Eu_2W_2O_9$:Nb, and $Eu_2W_2O_9$:Sm, an Eu activated sulfide phosphor such as $(Ca, Sr)S$:Eu, Eu activated aluminate phosphor such as $YAlO_3$:Eu, Eu activated silicate phosphors such as $Ca_2Y_8(SiO_4)_6O_2$:Eu and $LiY_9(SiO_4)_6O_2$:Eu, Ce activated aluminate phosphors such as $(Y, Gd)_3Al_5O_{12}$:Ce and $(Tb, Gd)_3Al_5O_{12}$:Ce, Eu activated oxide, nitride, or oxynitride phosphors such as $(Mg, Ca, Sr, Ba)_2Si_5(N, O)_8$:Eu, $(Mg, Ca, Sr, Ba)Si(N,O)_2$:Eu, and $(Mg, Ca, Sr, Ba)AlSi(N,O)_3$:Eu, an Eu, Mn activated halophosphate phosphor such as $(Sr, Ca, Ba, Mg)_{10}(PO_4)_6Cl_2$:Eu, Mn, Eu, Mn activated silicate phosphors such as $Ba_3MgSi_2O_8$:Eu, Mn and $(Ba, Sr, Ca, Mg)_3(Zn, Mg)Si_2O_8$:Eu, Mn, an Mn activated germinate phosphor such as $3.5MgO \cdot 0.5MgF_2 \cdot GeO_2$:Mn, an Eu activated oxynitride phosphor such as Eu activated $\alpha$ sialon, an Eu, Bi activated oxide phosphor such as $(Gd, Y, Lu, La)_2O_3$:Eu, Bi, an Eu, Bi activated oxysulphide phosphor such as $(Gd, Y, Lu, La)_2O_2S$:Eu, Bi, an Eu, Biactivated vanadate phosphor such as $(Gd, Y, Lu, La)VO_4$:Eu, Bi, an Eu, Ce activated sulfide phosphor such as $SrY_2S_4$:Eu, Ce, a Ce activated sulfide phosphor such as $CaLa_2S_4$:Ce, Eu, Mn activated phosphate phosphor such as $(Ba, Sr, Ca)MgP_2O_7$:Eu, Mn and $(Sr, Ca, Ba, Mg, Zn)_2P_2O_7$:Eu, Mn, an Eu, Mo activate tungstate phosphor such as $(Y, Lu)_2WO_6$:Eu, Mo, an Eu, Ce activated nitride phosphor such as $(Ba, Sr, Ca)_xSi_yN_2$:Eu, Ce (x, y, and z represents integers equal to or larger than 1), an Eu, Mn activated halophosphate phosphor such as $(Ca, Sr, Ba, Mg)_{10}(PO_4)_6(F, Cl, Br, OH)$:Eu, Mn, a Ce activated silicate phosphor such as $((Y, Lu, Gd, Tb)_{1-x-y}Sc_xCey)_2(Ca, Mg)_{1-r}(Mg, Zn)_{2+r}Si_{z-q}Ge_qO_{12+\delta}$, and the like.

Beside, in order to improve a color rendering property of radiated light from the semiconductor light emitting device or in order to improve light emission efficiency of the light emitting device, as the red phosphor, a red phosphor having half width of a red emitted light spectrum equal to or smaller than 20 nm (hereinafter sometimes referred to as "narrowband red phosphor") can be independently used or can be mixed with another red phosphor, in particular, a red phosphor having half width of a red emitted light spectrum equal to or larger than 50 nm and used. Examples of such a red phosphor include KSF, KSNAF, and a solid solution of KSF and KSNF represented by $A_{2+x}M_yMn_zF_n$ (A is Na and/or K; M is Si and Al; $-1 \leq x \leq 1$ and $0.9 \leq y+z \leq 1.1$ and $0.001 \leq z \leq 0.4$ and $5 \leq n \leq 7$), a manganese activated deep red (600 nm to 670 nm) Germanate phosphor such as $3.5MgO \cdot 0.5MgF_2 \cdot GeO:Mn$ indicated by a chemical formula $(k-x)MgO \cdot xAF_2 \cdot GeO_2:yMn^{4+}$ (in the formula, k is a real number of 2.8 to 5, x is a real number of 0.1 to 0.7, y is a real number of 0.005 to 0.015, and A is a calcium (Ca), strontium (Sr), barium (Ba), zinc (Zn), or a mixture of these), and a LOS phosphor indicated by a chemical formula $(La_{1-x-y}, Eu_x, Ln_y)_2O_2S$ (x and y respectively represent numbers satisfying $0.02 \leq x \leq 0.50$ and $0 \leq y \leq 0.50$ and Ln represents at least one kind of trivalent rare metal among Y, Gd, Lu, Sc, Sm, and Er).

Furthermore, $SrAlSi_4N_7$ which appears in International Publication No. WO 2008/096300 and $Sr_2Al_2Si_9O_2N_{14}$ : Eu which appears in US Patent Publication No. 7524437 can also be used.

Among the above, as the red phosphor, the CASN phosphor, the SCASN phosphor, the CASON phosphor, and the SBS phosphor are preferable.

The red phosphor exemplified above can be used either as a single kind or as a mixture of two or more kinds in any combination and in any ratio.

<2-3. Green Phosphors>

It is preferable that the wavelength of emission peak of a green phosphor is in the range of usually longer than 500 nm, particularly 510 nm or longer, further particularly 515 nm or longer, and usually 550 nm or shorter, particularly 540 nm or shorter, further particularly 535 nm or shorter. When that wavelength of emission peak is too short, the color tends to be bluish green. On the other hand, when it is too long, the color tends to be yellowish green. In both cases, the characteristics of its green light maydeteriorate.

The half width of emission peak of such a green phosphor is usually in the range of 1 nm to 80 nm. External quantum efficiency is usually equal to or higher than 60% and preferably equal to or higher than 70%. A weight median diameter is usually equal to or larger than 0.1 $\mu$m, preferably equal to or larger than 1.0 $\mu$m, and more preferably equal to or larger than 5.0 $\mu$m and usually equal to or smaller than 40 $\mu$m, preferably equal to or smaller than 30 $\mu$m, and more preferably equal to or smaller than 20 $\mu$m.

An example of such a green phosphor includes an Eu activated alkali earth silicate phosphor represented by $(Ba, Ca, Sr, Mg)_2SiO_4$: Eu (hereinafter sometimes abbreviated as "BSS phosphor") described in WO2007-091687.

Besides, as the green phosphor, it is also possible to use, for example, an EU activated oxynitride phosphor such as $Si_{6-z}Al_zN_{8-z}O_z:Eu$ ($0<z \leq 4.2$; hereinafter sometimes abbreviated as "$\beta$-SiAlON phosphor") described in Japanese Patent No. 3921545, an Eu activated oxynitride phosphor such as $M_3Si_6O_{12}N_2:Eu$ (M represents an alkali earth metal element; hereinafter sometimes abbreviated as "BSON phosphor") described in WO2007-088966, and a $BaMgAl_{10}O_{17}:Eu, Mn$ activated aluminate phosphor (hereinafter sometimes abbreviated as "GBAM phosphor") described in Japanese Patent Application Laid-open No. 2008-274254.

Besides, as the green phosphor, it is also possible to use an Eu activated alkali earth silicon oxynitride phosphor such as $(Mg, Ca, Sr, Ba)Si_2O_2N_2:Eu$, Eu activated aluminate phosphors such as $Sr_4Al_{14}O_{25}:Eu$ and $(Ba, Sr, Ca)Al_2O_4:Eu$, Eu activated silicate phosphor such as $(Sr, Ba)Al_2Si_2O_8:Eu$, $(3a, Mg)_2SiO_4:Eu$, $(Ba, Sr, Ca)_2(Mg, Zn)Si_2O_7:Eu$, and $(Ba, Ca, Sr, Mg)_9(Sc, Y, Lu, Gd)_2(Si, Ge)_6O_{24}:Eu$, a Ce, Tb activated silicate phosphor such as $Y_2SiO_5:Ce, Tb$, an Eu activated boric acid phosphate phosphor such as $Sr_2P_2O_7-Sr_2B_2O_5:Eu$, an Eu activated halosilicate phosphor such as $Sr_2Si_3O_8-2SrCl_2:Eu$, an Mn activated silicate phosphor such as $Zn_2SiO_4:Mn$, Tb activated aluminate phosphors such as $CeMgAl_{11}O_{19}:Tb$ and $Y_3Al_5O_{12}:Tb$, Tb activated silicate phosphors such as $Ca_2Y_8(SiO_4)_6O_2:Tb$ and $La_3Ga_5SiO14:Tb$, an Eu, Tb, Sm activated thiogallate phosphor such as $(Sr, Ba, Ca)Ga_2S_4:Eu, Tb, Sm$, Ce activated aluminate phosphors such as $Y_3(Al, Ga)_5O_{12}:Ce$ and $(Y, Ga, Tb, La, Sm, Pr, Lu)_3(Al, Ga)_5O_{12}:Ce$, Ce activated silicate phosphors such as $Ca_3Sc_2Si_3O_{12}:Ce$ and $Ca_3(Sc, Mg, Na, Li)_2Si_3O_{12}:Ce$, a CE activated oxide phosphor such as $CaSc_2O_4$: Ce, an Eu activated oxynitride phosphor such as Eu activated $\beta$ sialon, an Eu activated aluminate phosphor such as $SrAl_2O_4:Eu$, a Tb activated oxysulphide phosphor such as $(La, Gd, Y)_2O_2S:Tb$, a Ce, Tb activated phosphate phosphor such as $LaPO_4:Ce, Tb$, sulfide phosphors such as $ZnS:Cu, Al$ and $ZnS:Cu, Au, Al$, Ce, Tb activated borate phosphors such as $(Y, Ga, Lu, Sc, La)BO_3:Ce, Tb$, $Na_2Gd_2B_2O_7:Ce, Tb$, and $(Ba, Sr)_2(Ca, Mg, Zn)B_2O_6:K, Ce, Tb$, an Eu, Mn activated halosilicate phosphor such as $Ca_8Mg(SiO_4)_4C_{12}:Eu, Mn$, an Eu activated thioaluminate phosphor or thiogallate phosphor such as $(Sr, Ca, Ba)(Al, Ga, In)_2S_4:Eu$, an Eu, Mn activated halosilicate phosphor such as $(Ca, Sr)_8(Mg, Zn)(SiO_4)_4Cl_2:Eu, Mn$, and an Eu activated oxynitride phosphor such as $M_3Si_6O_9N_4:Eu$.

Further, $Sr_5Al_5Si_{21}O_2N_{35}:Eu$ which appears in International Publication No.WO 2009/072043 and $Sr_3Si_{13}Al_3N_{21}O_2$: Eu which appears in International Publication No. WO 2007/105631 can also be used.

Among the above, as the green phosphor, the BSS phosphor, the $\beta$-SiAlON phosphor, and the BSON phosphor are preferable.

The green phosphor exemplified above can be used either as a single kind or as a mixture of two or more kinds in any combination and in any ratio.

Besides, in order to improve a color rendering property of radiated light from the semiconductor light emitting device or in order to improve light emission efficiency of the light emitting device, as the green phosphor, a green phosphor having half width of a green emitted light spectrum equal to or smaller than 20 nm (hereinafter sometimes referred to as "narrowband green phosphor") can be independently used.

<2-4. Blue Phosphors>

The emission peak wavelength of blue phosphors is in the range of usually 420 nm or longer, preferably 430 nm or longer, more preferably 440 nm or longer, and usually less than 500 nm, preferably 490 nm or shorter, more preferably 480 nm or shorter, still more preferably 470 nm or shorter, and even more preferably 460 nm or shorter.

The half width of emission peak of a blue phosphor is usually in the range of 10 nm to 100 nm. External quantum efficiency is usually equal to or higher than 60% and preferably equal to or higher than 70%. A weight median diameter is usually equal to or larger than 0.1 $\mu$m, preferably equal to or larger than 1.0 $\mu$m, and more preferably equal to or larger than 5.0 $\mu$m and usually equal to or smaller than 40 $\mu$m, preferably equal to or smaller than 30 $\mu$m, and more preferably equal to or smaller than 20 $\mu$m.

Examples of such a blue phosphor include a europium activated calcium halophosphate phosphor represented by $(Ca, Sr, Ba)_5(PO_4)_3Cl:Eu$, a europium activated alkali earth chloroborate phosphor represented by $(Ca, Sr, Ba)_2B_5O_9Cl:Eu$, and a europium activated alkali earth aluminate phosphor represented by $(Sr, Ca, Ba)Al_2O_4:Eu$ or $(Sr, Ca, Ba)_4Al_{14}O_{25}:Eu$.

Besides, as the blue phosphor, it is also possible to use an Sn activated phosphate phosphor such as $Sr_2P_2O_7:Sn$, Eu activated aluminate phosphors such as $Sr_4Al_{14}O_{25}:Eu$, $BaMgAl_{10}O_{17}:Eu$, and $BaAl_8O_{13}:Eu$, Ce activated thio-gallate phosphors such as $SrGa_2S_4:Ce$ and $CaGa_2S_4:Ce$, Eu, Tb, Sm activated aluminate phosphor such as $(Ba, Sr, Ca)MgAl_{10}O_{17}:Eu$ and $BaMgAl_{10}O_{17}:Eu$, Tb, Sm, an Eu, Mn activated aluminate phosphor such as $(Ba, Sr, Ca)MgAl_{10}O_{17}:Eu$, Mn, Eu, Tb, Sm activated halophosphate phosphors such as $(Sr, Ca, Ba, Mg)_{10}(PO_4)_6Cl_2:Eu$ and $(Ba, Sr, Ca)_5(PO_4)_3(Cl, F, Br, OH):Eu$, Mn, Sb, Eu activated silicate phosphor such as $BaAl_2Si_2O_8:Eu$ and $(Sr, Ba)_3MgSi_2O_8:Eu$, an Eu activated phosphate phosphor such as $Sr_2P_2O_7:Eu$, sulfide phosphors such as $ZnS:Ag$ and $ZnS:Ag, Al$, a Ce activated silicate phosphor such as $Y_2SiO_5:Ce$, a tungstate phosphor such as $CaWO_4$, Eu, Mn activated boric acid phosphate phosphors such as $(Ba, Sr, Ca)BPO_5:Eu$, Mn, $(Sr, Ca)_{10}(PO_4)_6·nB_2O_3:Eu$, and $2SrO·0.84P_2O_5·0.16B_2O_3:Eu$, and an Eu activated halosilicate phosphor such as $Sr_2Si_3O_3·2SrCl_2:Eu$.

Of the foregoing phosphors, $(Sr, Ca, Ba)_{10}(PO_4)_6Cl_2:Eu^{2+}$, $BaMgAl_{10}O_{17}:Eu$ can preferably be used. Among the phosphors indicated by $(Sr, Ca, Ba)_{10}(PO_4)_6Cl_2:Eu^{2+}$, a phosphor indicated by $Sr_aBa_bEu_x(PO_4)_cCl_d$ (c, d, and x are numbers satisfying $2.7 \leq c \leq 3.3$, $0.9 \leq d \leq 1.1$, and $0.3 \leq x \leq 1.2$ and x is preferably $0.3 \leq x \leq 1.0$. Further, a and b satisfy a condition $a+b-5-x$ and $0.05 \leq b/(a+b) \leq 0.6$ and $b/(a+b)$ is preferably $0.1 \leq b/(a+b) \leq 0.6$) can be preferably used.

Besides, in order to improve a color rendering property of radiated light from the semiconductor light emitting device or in order to improve light emission efficiency of the light emitting device, as the blue phosphor, a blue phosphor having half width of a blue emitted light spectrum equal to or smaller than 20 nm (hereinafter sometimes referred to as "narrowband blue phosphor") can be independently used.

<2-5. Yellow Phosphors>

The emission peak wavelength of yellow phosphors is in the range of usually 530 nm or longer, preferably 540 nm or longer, and more preferably 550 nm or longer, and usually 620 nm or shorter, preferably 600 nm or shorter, and more preferably 580 nm or shorter.

The half width of emission peak of such a yellow phosphor is usually in the range of 80 nm to 130 nm. External quantum efficiency is usually equal to or higher than 60% and preferably equal to or higher than 70%. A weight median diameter is usually equal to or larger than 0.1 $\mu$m, preferably equal to or larger than 1.0 $\mu$m, and more preferably equal to or larger than 5.0 $\mu$m and usually equal to or smaller than 40 $\mu$m, preferably equal to or smaller than 30 $\mu$m, and more preferably equal to or smaller than 20 $\mu$m.

Examples of such a yellow phosphor include various phosphors of such as oxide, nitride, oxynitride, sulfide and oxysulfide. In particular, examples of the yellow phosphor include garnet phosphors including garnet structures represented by $RE_3M_5O_{12}:Ce$ (RE represents at least one kind of element selected from a group consisting of Y, Tb, Gd, Lu, and Sm and M represents at least one kind of element selected from a group consisting of Al, Ga, and Sc) and $Ma_3Mb_2Mc_3O_{12}:Ce$ (Ma represents a bivalent metal element, Mb represents a trivalent metal element, and Mc represents a tetravalent metal element), an orthosilicate phosphor represented by $AE_2MdO_4:Eu$ (AE represents at least one kind of element selected from a group consisting of Ba, Sr, Ca, Mg, and Zn and Md represents Si and/or Ge), an oxynitride phosphor obtained by replacing a part of oxygen of constituent elements of the phosphors with nitride, and a phosphor obtained by activating, with Ce, a nitride phosphor including a $CaAlSiN_3$ structure such as $AEAlSiN_3:Ce$ (AE represents at least one kind of element selected from a group consisting of Ba, Sr, Ca, Mg, and Zn).

Furthermore, additionally, examples of yellow phosphors which can be used include sulfide phosphors such as $CaGa_2S_4:Eu$, $(Ca, Sr) Ga^2S_4:Eu$, $(Ca, Sr) (Ga, Al)_2S_4:Eu$, Eu- activated phosphors such as oxynitride phosphors which have an SiAlON structure such as $Ca_x(Si, Al)_{12}(O, N)_{16}$:Eu, Eu-activated or Eu- and Mn-activated halide borate phosphors such as $(M_{1-A-B}Eu_AMn_B)_2(BO_3)_{1-P}(PO_4)_PX$ (where M represents at least one element selected from the group consisting of Ca, Sr, and Ba, and X represents at least one element selected from the group consisting of F, Cl, and Br. A, B, and P each represent numbers which satisfy $0.001 \leq A \leq 0.3$, $0 \leq B \leq 0.3$, $0 \leq P \leq 0.2$), and Ce-activated nitride phosphors which have a structure of $La_3Si_6N_{11}$ and may contain alkaline earth metals may be used. Note that the foregoing Ce-activated nitride phosphors may also be partially substituted with Ca and O.

A wavelength conversion layer may be fabricated by mixing a phosphor powder with binder resin and organic solvent to form a paste, applying the paste to a transparent substrate or pouring the paste into the hollow portion of a package, and performing drying and calcination to remove the organic solvent, or may be fabricated by forming a paste from the phosphor and organic solvent without the use of a binder, and press-molding the dried sinter. If a binder is used, the binder can be used without restrictions on the type: an epoxy resin, a silicone resin, an acrylic resin, or a polycarbonate resin or the like is preferred. A light reflection type wavelength conversion layer can be manufactured by applying the paste to a reflecting section of a housing, which reflects light, and performing drying and firing to remove an organic solvent.

In a case where a transparent substrate which transmits visible light is used, there are no particular restrictions on the material of the substrate as long as the substrate is transparent to visible light, and glass and plastic (for example epoxy resin, silicone resin, acrylic resin, and polycarbonate resin or the like) can be used. The semiconductor light emitting device of the present invention includes a cut filter explained below. Therefore, in the case of excitation by wavelengths in the normal ultraviolet, near ultraviolet, and violet regions, it is also possible to use a material inferior in durability.

<2-6. Transmission type wavelength conversion layer>

The wavelength conversion layer used in the semiconductor light emitting device of the present invention may be formed in a mode of a light transmission type wavelength conversion layer or in a mode of a light reflection type wavelength conversion layer. Both the wavelength conversion layers can be manufactured by appropriately using the phosphor, the binder resin, and the organic solvent illustrated above.

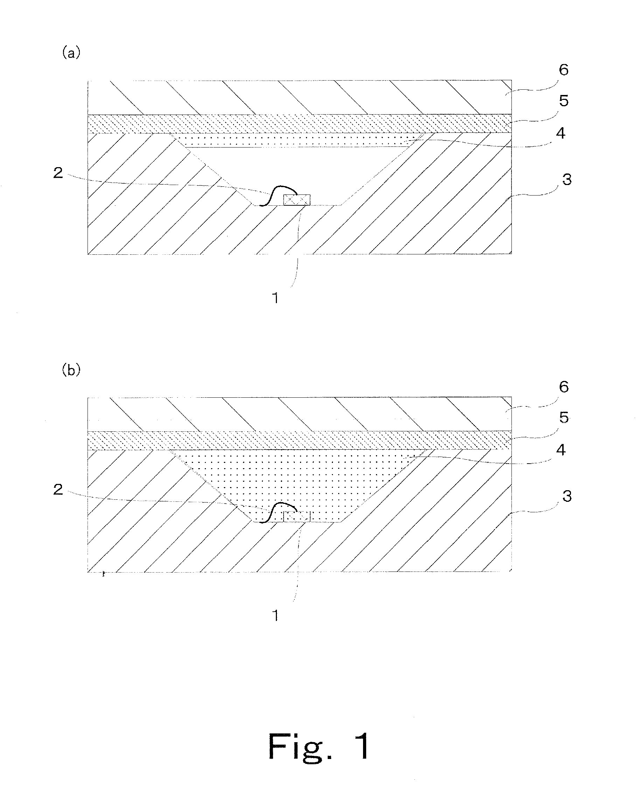

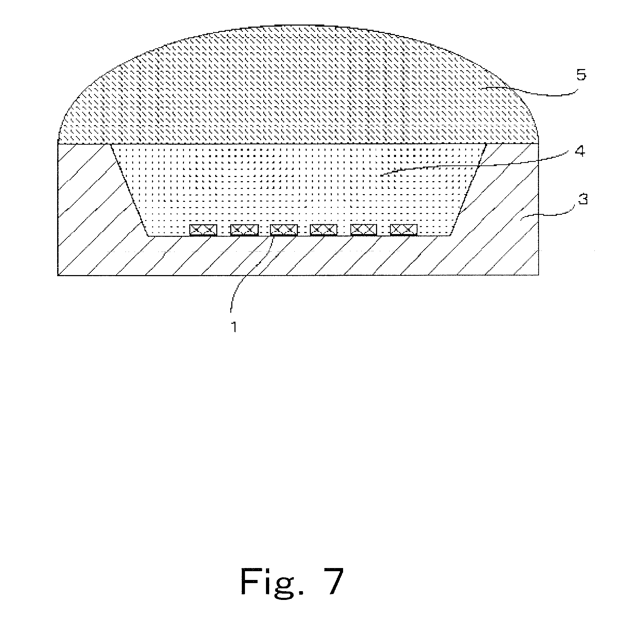

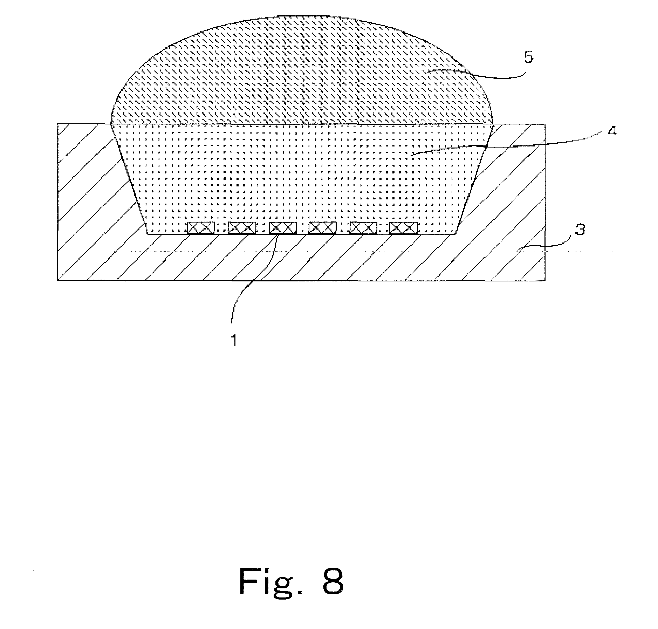

The transmission type wavelength conversion layer emits fluorescent light using, as excitation light, light emitted by the semiconductor light emitting element. However, light not subjected to wavelength conversion among fluorescent lights emitted by the wavelength conversion layer and lights emitted by the semiconductor light emitting element is mainly directly emitted from the semiconductor light emitting device. Examples of the semiconductor light emitting device including the wavelength conversion layer of such a form include semiconductor light emitting devices shown in Figs. 1 to 8.

<2-7. Reflection type wavelength conversion layer>

The reflection type wavelength conversion layer is a wavelength conversion layer that once reflects light emitted by the semiconductor light emitting element and emits light from a separately-provided opening section. In this case, the semiconductor light emitting device includes a housing including an opening section capable of emitting light and a reflecting section configured to reflect light. The wavelength conversion layer is provided in the reflecting section of the housing. When the light emitted by the semiconductor light emitting element is made incident on the wavelength conversion layer, the wavelength conversion layer emits fluorescent light using the incident light as excitation light. However, the fluorescent light is reflected by the presence of the reflecting section of the housing and emitted from the separately-provided opening section of the housing.

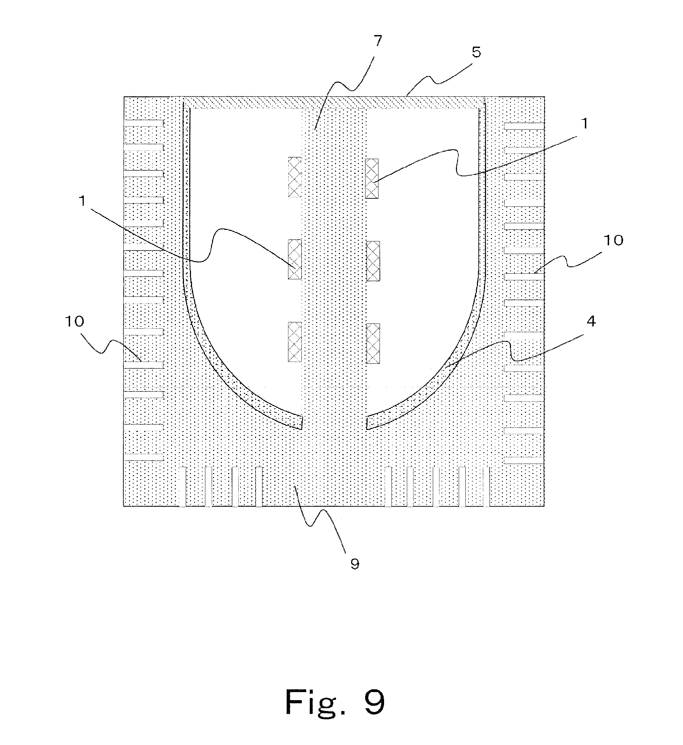

With such a form, the light is subjected to color mixture and a white light emitting device without color separation and having a natural appearance is obtained. Examples of the semiconductor light emitting device including the wavelength conversion layer of such a form include a semiconductor light emitting device shown in Fig. 9.

<3. Cut filter>

The semiconductor light emitting device of the present invention includes a cut filter configured to absorb light having a short wavelength equal to or less than 430 nm and transmit light having a long wavelength greater than 430 nm. The semiconductor light emitting device emits light through the cut filter.

Conventionally, when the cut filter is used in the semiconductor light emitting device, a reflection type cut filter is used. Light to be cut by the filter is light having a short wavelength and is not light contributing to formation of white light even if the light is emitted from the semiconductor light emitting device or is not light in a visible light region. Therefore, even if the light is directly emitted from the semiconductor light emitting device, the light does not contribute to light emission efficiency of the semiconductor light emitting device. Therefore, for the purpose of improving light emission efficiency, it has been considered to reflect, with the reflection type cut filter, light not subjected to wavelength conversion among lights emitted by the semiconductor light emitting element and use the light as excitation light of the phosphor again (see Patent Document 1).

However, when the inventors examined, it has been found that the reflection type cut filter cannot sufficiently reflect light and an extremely large amount of light is transmitted through the cut filter. This is because, in the case of the semiconductor light emitting device, a traveling direction of light made incident on the cut filter is not one direction. That is, since the cut filter has angle dependency, the cut filter satisfactorily reflects incident light from a specific direction but cannot reflect and transmits the incident light from other directions. In general, when light is made incident on a layer including a phosphor from a semiconductor light emitting element, the light is emitted as scattered light. Therefore, the inventors have conceived that light cannot be sufficiently reflected in the form in which the reflection type cut filter is included in the semiconductor light emitting device and the function of the cut filter is not sufficiently displayed.

The inventors have also found through a simulation explained below that light emission efficiency increases as a whole when a certain amount of excitation light is emitted from the light emitting device without being subjected to wavelength conversion. A reason for this is uncertain. However, the inventors consider that absorption of light by phosphors, cascade excitation, and the like are causes.

Therefore, in the present invention, an unexpected result has been obtained that it is possible to improve light emission efficiency by adopting a method opposite to the conventional idea for improving the light emission efficiency reusing light not subjected to wavelength conversion among excitation lights emitted by the semiconductor light emitting element, that is, a method of causing the cut filter to absorb a part of the excitation lights not subjected to the wavelength conversion and discarding the part of the excitation lights.

The cut filter included in the semiconductor light emitting device of the present invention absorbs light having a short wavelength equal to or less than 430 nm and transmits light having a long wavelength greater than 430 nm. The absorption of the light having the short wavelength equal to or less than 430 nm and the transmission of the light having the long wavelength greater than 430 nm do not need to be 100%. As explained below, in a spectrum of light emitted by the semiconductor light emitting device, light emission peak intensity deriving from emitted light of the semiconductor light emitting element with respect to maximum intensity of the spectrum is not specifically limited. However, it is preferable to use a cut filter that reduces the light emission peak intensity to 50% or lower.

In order to set the spectrum of the light emitted by the semiconductor light emitting device within the range of the present invention, the cut filter is preferably a cut filter that absorbs 50% or more of light having a wavelength equal to or less than 430 nm. By using such a cut filter, it is possible to reduce a light emission peak deriving from the emitted light of the semiconductor light emitting element.

By reducing the light emission peak deriving from the emitted light of the semiconductor light emitting element, a change in a ting of light emitted from the semiconductor light emitting device due to emission of violet light is suppressed when the semiconductor light emitting element is a semiconductor light emitting element that emits violet light.

On the other hand, when the semiconductor light emitting element is a semiconductor light emitting element that emits near ultraviolet or ultraviolet light, it is possible to suppress possibility of damage to skin or the like due to strong energy of the light.

The cut filter is preferably a cut filter that absorbs 70% or more of light having a wavelength 360 nm or more and 400 nm or less and more preferably a cut filter that absorbs 80% or more of the light. The cut filter is preferably a cut filter that absorbs 70% or more of light having wavelength 360 nm or more and 430 nm or less and more preferably a cut filter that absorbs 80% or more of the light. Consequently, it is possible to improve a color rendering property by sufficiently cutting the light from the semiconductor light emitting element.

In the present invention, light absorptance of the cut filter can be calculated by measuring radiated light, reflected light, and transmitted light with a spectrophotometer and using values of the radiated light, the reflected light, and the transmitted light.

The cut filter used in the present invention is an absorption type cut filter. Therefore, unlike the reflection type cut filter, fluctuation in transmittance of light due to an incident angle of the light is small. That is, it is preferable that, when an incident angle 0 is changed to an arbitrary angle in a range of 0 to 180°, fluctuation $\Delta t\theta$ of transmittance $t\theta$ of light made incident on the cut filter surface at the incident angle $\theta$ is equal to or lower than 50%. The fluctuation $\Delta t\theta$ is more preferably not more than 40% and even more preferably not more than 30%.

A ratio ($t\theta_{max}/S$) of incident light $t\theta_{max}$ at an angle of incident light, which allows the incident light to be transmitted most with respect to the incident light, to incident light S is defined as the fluctuation $\Delta t\theta$ of the transmission of the light. The fluctuation in the transmittance of the light can be calculated by measuring transmitted light for each of angles of the incident light and comparing the intensity of the incident light and the intensity of transmitted light.

It is preferable that the cut filter of the present invention has a large change in transmittance in the vicinity of 430 nm, that is, shows a sharp gradient in the vicinity of 430 nm in a graph in which a wavelength (nm) is plotted on the abscissa and transmittance is plotted on the ordinate. Specifically, it is preferable that the gradient is equal to or larger than 50%/10nm in the vicinity of 430 nm. Note that the vicinity of 430 nm means 400 nm to 450 nm and preferably means 410 nm to 440 nm.

Further, the semiconductor light emitting device of the present invention includes a semiconductor light emitting element configured to emit light having a light emission peak in a wavelength equal to or less than 430 nm. Light emission efficiency is larger as excitation light transmittance is higher. However, since light having a short wavelength has high energy, a discoloration damage coefficient (hereinafter sometimes also referred to simply as "damage coefficient") is also large. Therefore, it is preferable that the cut filter of the present invention absorbs a wavelength to reduce the damage coefficient. The damage coefficient obtained when the semiconductor light emitting device includes the cut filter is usually equal to or smaller than 0.020, preferably equal to or smaller than 0.012, and more preferably equal to or smaller than 0.010. The smaller damage coefficient is better. A lower limit of the damage coefficient is not particularly set. However, the damage coefficient is usually equal to or larger than 0.0001. By setting the damage coefficient in this range, it is possible to protect an irradiated object from discoloration and fading (color fade-out) and prevent damage.

The discoloration damage coefficient is a numerical value converted from a degree of discoloration specified by the N.B.S. (the present National Institute of Standard Technology) using color paper. In general, a light source having a smaller value of the discoloration damage coefficient has a less influence on an irradiated object. The damage coefficient can be calculated by an expression shown below.

[Math 1]

$$\left(\frac{D}{lx}\right) = \frac{\sum\limits_{300}^{580} P(\lambda) \cdot D(\lambda) \cdot \Delta\lambda}{\sum\limits_{380}^{780} P(\lambda) \cdot V(\lambda) \cdot \Delta\lambda}$$

(where, (D/lx) represents a damage coefficient per unit illuminance, $P(\lambda)$ represents a spectral energy distribution, $D(\lambda)$ represents a relative damage degree N.B.S, and $V(\lambda)$ represents standard relative luminosity CIE.)

As the cut filter having the function, a commercially available cut filter may be used. Alternatively, the cut filter may be manufactured to have the function. As the commercially available cut filter, for example, CLAREX UV manufactured by Nitto Jushi Kogyo Co., Ltd., an SC filter manufactured by Fujifilm Corporation, a UV cut filter manufactured by OMG Co., Ltd., and the like can be used. When the cut filter is manufactured, it is possible to manufacture the cut filter by preparing translucent resin and containing a light-absorbing substance in the resin. The resin is preferably transparent resin that transmits light. For example, acrylic resin, epoxy resin, silicone resin, and the like can be used as appropriate.

Examples of the light-absorbing substance include an inorganic substance and an organic substance. Examples of the inorganic substance include $ZnO$, $TiO_2$, $CeO_2$, and $SiO_2$. As these inorganic substances, commercially available inorganic substances may be used. For example, as $ZnO$, a NANOFINE series manufactured by Sakai Chemical Industry Co., Ltd. can be used. As $TiO_2$, an ST-400 series and an ST-700 series manufactured by Titan Kogyo Ltd. can be used. As $CeO_2$, $CeO_2$ manufactured by Across Corporation, cerium oxide manufactured by Moriyama Shouji Co., Ltd., and the like can be used.

On the other hand, examples of the organic substance include a dye and include an azo-based dye and an anthraquinone-based dye. From the viewpoint of durability, it is preferable to use the inorganic substance.

The cut filter used in the present invention is preferably a single layer. The reflection type cut filter has the angle dependency as explained above. Therefore, when it is attempted to cause the reflection type cut filter to reflect light having a wide angle, the reflection type cut filter has to be a laminated body including a plurality of layers. Since the cut filter of the present invention is the absorption type cut filter, the cut filter can be configured by a single layer.

Since the cut filter used in the present invention is a light absorption type cut filter, absorbed light is sometimes converted into heat to generate heat. Therefore, the semiconductor light emitting device preferably includes a heat radiation mechanism.

<4. Further members which may be included in the light emitting device of the present invention>

The light emitting device of the present invention can comprise a package for holding a semiconductor light emitting element and which has an optional shape and material. Specific shapes which can be used are plate shape, cup shape, or any suitable shape depending on the application. Among these shapes, a cup-shaped package is preferable since this shape is able to retain directivity in the light emission direction and is able to effectively use the light emitted by the light emitting device. In a case where a cup-shaped package is adopted, the surface area of the opening for emitting light is preferably 20% or more and 600% or less of the base surface area. Further, possible package materials which can be used include suitable materials depending on the application such as inorganic materials such as metals, glass alloys and carbons, and organic materials such as synthetic resins.

If a package is used in the present invention, a material with a high reflectance across the whole near-ultraviolet and visible light ranges is preferable. Highly reflective packages of this type include packages which are formed of silicone resin and which comprise light scattering particles. Possible examples of light scattering particles include titania and alumina.

When the wavelength conversion layer is the reflection type wavelength conversion layer, the semiconductor light emitting device can include a housing. The housing includes an opening section capable of emitting light and a reflecting section configured to reflect light radiated by the semiconductor light emitting element.

From the viewpoint of light emission efficiency, a portion other than the opening section of the housing is made of a material capable of reflecting the light radiated by the semiconductor light emitting element. Examples of such a material include various kinds of ceramics, resin, glass, and metal such as aluminum. These materials can be combined or compounded to be used.

As the resin, for example, silicone resin, polycarbonate resin, ABS resin, epoxy resin, phenol resin, polyphthalamide resin (PPA), polyphenylene sulfide (PPS), liquid crystal polymer (LCP), acrylic resin, PBT resin, bismaleimide triazine resin (BT resin), and the like are preferable.

As the ceramics, for example, alumina, aluminumnitride, silicon nitride, boron nitride, beryllia, mullite, forsterite, steatite, cordierite, zirconium, low-temperature baked ceramics, and ceramics containing these as components are preferable.

Further, metal wiring for supplying power from the outside to the semiconductor light emitting element and a cap to protect the light emission direction side of the phosphor layer, and so on, can be suitably disposed.

<5. The light emitting device of the present invention>

A semiconductor light emitting device according to a first aspect of the present invention is characterized in that, at a spectrum of light emitted by the semiconductor light emitting device, light emission peak intensity deriving from a semiconductor light emitting element with respect to maximum intensity of the spectrum is suppressed low. A cut filter is used to show extremely high light emission efficiency. In addition, it is possible to emit light having a high color rendering property.

The emission peak intensity derived from the semiconductor light emitting element is preferably 50% or less, more preferably 30% or less, and even more preferably 20% or less.

On the other hand, a semiconductor light emitting device according to a second aspect of the present invention is characterized in that the semiconductor light emitting device contains at least one narrowband phosphor selected from a group consisting of a narrowband red phosphor, a narrowband green phosphor, and a narrowband blue phosphor, and light emission peak intensity deriving from a semiconductor light emitting element with respect to maximum intensity of the spectrum is equal to or lower than 20%.

The emission peak intensity derived from the semiconductor light emitting element is preferably not more than 15% and more preferably not more than 10%.

When the semiconductor light emitting device contains the narrowband red phosphor and/or the narrowband green phosphor, if the light emission peak intensity deriving from the semiconductor light emitting element with respect to the maximum intensity of the spectrum exceeds 20%, a color rendering property of light emitted by the semiconductor light emitting element tends to be insufficient.

It is preferable that the semiconductor light emitting device of the present invention intensely emits light from the semiconductor light emitting element to cause the semiconductor light emitting element to emit light. Specifically, light emission peak intensity of light emitted from the semiconductor light emitting element and reaching the cut filter without being subjected to wavelength conversion by the wavelength conversion layer is preferably equal to or higher than 50%, more preferably equal to or higher than 70%, and still more preferably equal to or higher than 100% of maximum intensity in a spectrum of the light. Meanwhile, the emission peak intensity is preferably not more than 250% and more preferably not more than 200%.

Since the semiconductor light emitting device of the present invention includes the cut filter, the semiconductor light emitting device can emit light having a high color rendering property. The light emitted from the semiconductor light emitting device has a value of general color rendering index Ra preferably equal to or greater than 70, more preferably equal to or greater than 80, even more preferably equal to or greater than 90.

A value of special color rendering index R9 is preferably is equal to or greater than 0 and more preferably equal to or greater than 80.

A value of special color rendering index R12 is preferably is equal to or greater than 0 and more preferably equal to or greater than 80.

The present invention will be described hereinbelow with reference to embodiments of the light emitting device of the present invention. The present invention is not limited to the following embodiments, rather, optional modifications can be carried out without departing from the spirit and scope of the present invention.

In Fig. 1 to Fig. 8, overall diagrams of a semiconductor light emitting device in which a wavelength conversion layer is a light transmission type wavelength conversion layer among semiconductor light emitting devices including cut filters of the present invention are shown.

In Fig. 1(a), in the semiconductor light emitting device of the present invention, a semiconductor light emitting element 1 is arranged on the bottom surface of a recess of a package 3, fixed by a bonding wire 2, and connected to an external power supply. Further, a wavelength conversion layer 4 is disposed in an opening in the package 3. A cut filter 5 is provided on a light emission side of the wavelength conversion layer 4. The cut filter 5 absorbs excitation light not subjected to wavelength conversion in the wavelength conversion layer 4, that is, light emitted by the semiconductor light emitting element 1 among lights emitted from the wavelength conversion layer 4. A transparent substrate 6 is arranged on a light emission side of the cut filter 5. The transparent substrate 6 plays a role of protecting the semiconductor light emitting device from a shock and the like from the outside. On the other hand, in Fig. 1(b), the recess of the package is sealed by the wavelength conversion layer.

The semiconductor light emitting element 1 emits light having a light emission peak in a wavelength equal to or less than 430 nm. Specifically, a violet semiconductor light emitting element that emits light in a violet region, a near ultraviolet semiconductor light emitting element that emits light in a near ultraviolet region, or an ultraviolet semiconductor light emitting element that emits light in an ultraviolet region is used. Only one semiconductor light emitting element 1 may be arranged. A plurality of the semiconductor light emitting elements 1 may be arranged in a flat shape. The size of the semiconductor light emitting element is not particularly limited.

The package 3 holds the semiconductor light emitting element 1 and the wavelength conversion layer 4 and, in this embodiment, is cup-shaped with an opening and a hollow portion, and the semiconductor light emitting element 1 is disposed on the bottom face of the hollow portion. If the package 3 is cup-shaped, the directivity of the light emitted from the semiconductor light emitting device can be retained and the emitted light can be better used. Note that the specifications of the hollow portion of the package 3 are set as specifications enabling the semiconductor light emitting device to emit light in a predetermined direction. Further, the bottom portion of the hollow portion of the package 3 comprises electrodes (not shown) for supplying power to the semiconductor light emitting element 1 from the outside of the semiconductor light emitting device. A highly reflective package is preferably used for the package 3, thereby enabling the light striking the wall surface (tapered portion) of the package 3 to be emitted in a predetermined direction and making it possible to prevent a loss of light.

The wavelength conversion layer 4 is disposed at the opening of the package 3 (Fig. 1 (a)). Alternatively, the recess of the package 3 is sealed by the wavelength conversion layer 4 (Fig. 1(b)). The hollow portion of the package 3 is covered by the wavelength conversion layer 4 and the light from the semiconductor light emitting element 1 does not pass through the wavelength conversion layer 4 and is not emitted from the semiconductor light emitting device. In Fig. 1(a), the semiconductor light emitting element 1 and the wavelength conversion layer 4 are apart from each other. The distance between the semiconductor light emitting element 1 and the wavelength conversion layer 4 is preferably equal to or larger than 0.1 mm, more preferably equal to or larger than 0. 3 mm, still more preferably equal to or larger than 0.5 mm, and particularly preferably equal to or larger than 1 mm and is preferably equal to or smaller than 500 mm, more preferably equal to or smaller than 300 mm, still more preferably equal to or smaller than 100 mm, and particularly preferably equal to or smaller than 10 mm. With this form, it is possible to prevent a weakening of the excitation light for each unit area of the phosphor and degradation of the light of the phosphor, and even if the temperature of the semiconductor light emitting element rises, a rise in the temperature of the wavelength conversion layer can be prevented. By adopting such a form, even when the semiconductor light emitting element and an electrode are connected using a bonding wire, it is possible to suppress heat emitted from the wavelength conversion layer from being transferred to near the bonding wire. Further, even if a crack occurs in a phosphor layer, it is possible to suppress a tensile force of the crack from being transmitted to the bonding wire. As a result, it is possible to prevent breaking of the bonding wire.

The cut filter 5 is a filter that absorbs light having a short wavelength equal to or less than 430 nm, that is, light emitted by the semiconductor light emitting element 1. According to the presence of the cut filter 5, the semiconductor light emitting device of the present invention can attain both of high light emission efficiency and a high color rendering property. In addition, it is possible to absorb light having a short wavelength and a color rendering property is improved. According to the presence of the cut filter 5, since short-wavelength light having high energy is cut, a problem does not occur in durability even if resin susceptible to light such as polycarbonate is used as the transparent substrate 6. By using the resin such as polycarbonate as the transparent substrate 6, it is easy to apply surface treatment and it is possible to improve light extraction efficiency.

Since the cut filter 5 is provided in the semiconductor light emitting device, when the semiconductor light emitting device is used as an illumination device, it is unnecessary to further include a cut filter. For example, labor and time for attaching a cut filter to a lens arranged on the outer side of the semiconductor light emitting device are saved.

A form in which the cut filter 5 is supported by the transparent substrate 6 is preferable. In Fig. 1, the cut filter 5 is arranged on a chip side of the transparent substrate 6. However, it is preferable that the cut filter 5 is supported by the transparent substrate 6. A form of the support is not particularly limited. A method such as bonding only has to be used. It is also possible that a not-shown another transparent substrate and the cut filter 5 are laminated and the cut filter 5 is supported by the transparent substrate and then arranged in the semiconductor light emitting device. Since the cut filter 5 is supported by the other transparent substrate, it is easy to manufacture the semiconductor light emitting device.

When the cut filter 5 is supported by the transparent substrate in this way, the surface of the transparent substrate on a side opposed to the cut filter is preferably subjected to non-reflection treatment. Such non-reflection treatment is preferably performed because absorption of light having a wavelength equal to or less than 430 nm is improved. As the non-reflection treatment, a publicly-known method only has to be adopted. Examples of the non-reflection treatment include a method of applying extremely small unevenness to the surface of the transparent substrate and a method of forming a reflection prevention film on the surface of the transparent substrate.

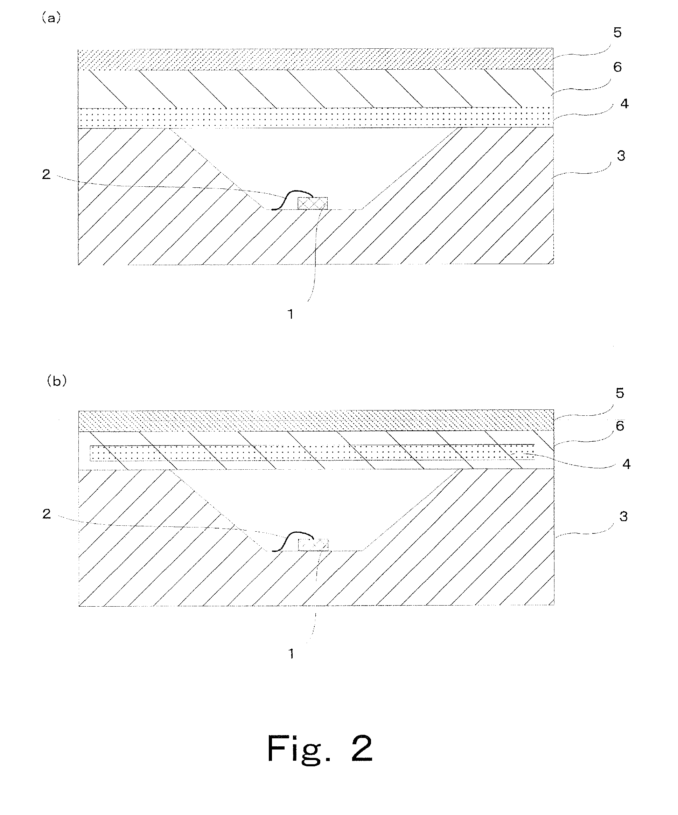

Fig. 2 is a semiconductor light emitting device including the cut filter 5 on the outermost surface of the semiconductor light emitting device on a light emission side. As shown in Fig. 2(a), it is also possible that the transparent substrate and the cut filter 5 are laminated, then, the wavelength conversion layer 4 is laminated on the transparent substrate on a surface on the opposite side of the cut filter laminated surface or the wavelength conversion layer 4 is laminated to be superimposed on the cut filter laminated surface on the transparent substrate, whereby the cut filter 5 and the wavelength conversion layer 4 are supported by the transparent substrate and then arranged in the semiconductor light emitting device. Since the cut filter 5 and the wavelength conversion layer 4 are supported by the other transparent substrate, it is easy to manufacture the semiconductor light emitting device. The position of the cut filter 5 is not limited as long as the cut filter 5 is arranged further on the light emission side than the wavelength conversion layer 4.

As shown in Fig. 2(b), a form in which the wavelength conversion layer 4 is arranged in the transparent substrate 6 is also possible. When the transparent substrate 6 is a glass material, the transparent substrate 6 can be manufactured by preparing two glass plates, forming the wavelength conversion layer 4 on one glass plate using application, screen printing, or the like, and sandwiching the wavelength conversion layer 4 with the other glass to seal the wavelength conversion layer 4. When the transparent substrate 6 is resin, as in the case of glass, it is also possible to sandwich the wavelength conversion layer 4. The transparent substrate 6 may be formed as a transparent substrate integrated with the wavelength conversion layer by kneading the phosphor forming the wavelength conversion layer 4 into the resin.

An additive for accelerating scattering of light may be added to the transparent substrate 6 according to necessity. Surface treatment for accelerating scattering of light maybe applied to a light emission surface of the transparent substrate 6. Examples of the surface treatment to the transparent substrate include a rough surface on which micro unevenness is formed, a surface given with a V groove and triangular prism shape, a surface formed in a V groove and triangular prism shape by forming a plurality of V grooves parallel to one another to thereby alternately providing prism-like ridges having a triangular cross section and the V grooves in parallel, a surface formed in a cylindrical prism shape, and a surface on which pyramid-like projections of square pyramids are regularly arrayed.

A light extraction layer may be provided further on the light emission surface side of the transparent substrate 6. When the wavelength conversion layer 4 including the phosphor is kneaded into the transparent substrate 6, the light extraction layer is provided on the light emission surface side of the transparent substrate 6. When the wavelength conversion layer 4 including the phosphor is provided on the semiconductor light emitting element side of the transparent substrate 6, the transparent substrate 6 may be formed as an extraction layer or the light extraction layer may be provided on the light emission surface side of the transparent substrate 6.

At least a part of lights emitted from the wavelength conversion layer 4 including the phosphor is scattered by the light extraction layer, whereby the lights are satisfactorily combined. It is possible to obtain high-quality emitted light without unevenness.

In order to accelerate the scattering of light, as explained above, it is sufficient to add the additive to the transparent substrate 6 or apply the surface treatment to the light emission surface of the transparent substrate 6.

At this point, it is possible to appropriately set the extending directions, the sizes, and the numbers of the V grooves and the ridges according to a light emission characteristic required of the semiconductor light emitting device, an optical characteristic of the transparent substrate 6, a light emission characteristic from the wavelength conversion layer 4 including the phosphor, or the like. It is also possible to vary the sizes of the ridges and the V grooves without setting the sizes the same. It is also possible to appropriately set a distribution of the ridges and the V grooves having the different sizes according to the light emission characteristic required of the semiconductor light emitting device, the optical characteristic of the transparent substrate 6, the light emission characteristic from the wavelength conversion layer 4 including the phosphor, or the like.

The pyramids are not limited to the square pyramids and may be triangular pyramids, hexagonal pyramids, or the like or may be cones. It is possible to appropriately set the number, the positions, the size, or the like of the pyramids according to the light emission characteristic required of the semiconductor light emitting device, the optical characteristic of the transparent substrate 6, the light emission characteristic from the wavelength conversion layer 4 including the phosphor, or the like. Further, it is also possible to vary the respective pyramids without setting the pyramids the same. It is also possible to appropriately set a distribution of the different pyramids according to the light emission characteristic required of the semiconductor light emitting device, the optical characteristic of the transparent substrate 6, the light emission characteristic from the wavelength conversion layer 4 including the phosphor, or the like.

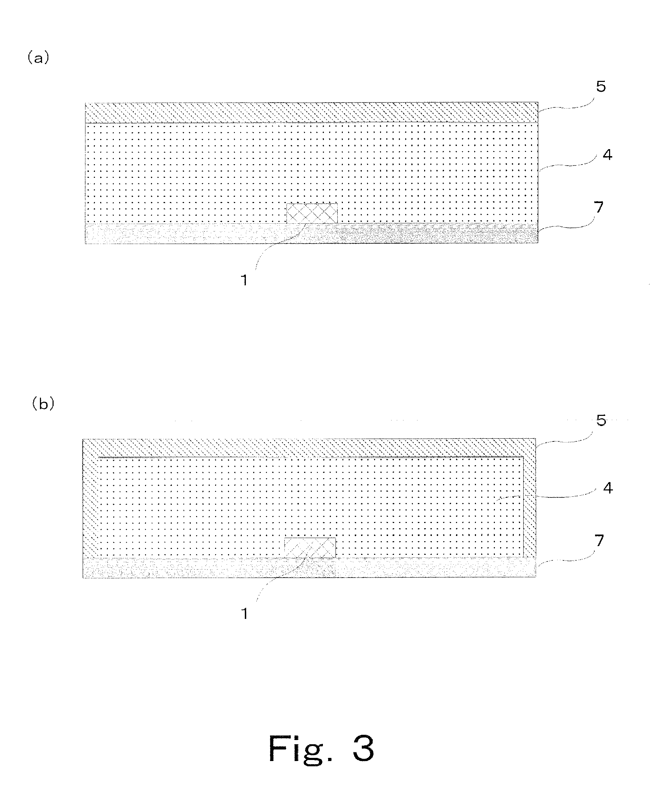

Fig. 3 is a semiconductor light emitting device having a form in which the semiconductor light emitting element 1 is furnished on a supporting body 7. The supporting body 7 is not particularly limited as long as the supporting body 7 is a flat plate. Any supporting body may be used.

The wavelength conversion layer 4 plays a role of sealing the semiconductor light emitting element 1. For example, the wavelength conversion layer 4 may be manufactured by mixing a phosphor in epoxy resin, silicone resin, or the like to prepare slurry, applying the slurry on the supporting body 7 and the semiconductor light emitting element 1, and forming the wavelength conversion layer 4. The cut filter 5 is laminated in a light emitting direction of the wavelength conversion layer 4. Consequently, it is possible to easily manufacture the semiconductor light emitting device. As shown in Fig. 3(a), nothing may be arranged on a side surface of the wavelength conversion layer. However, as shown in Fig. 3(b), a form in which the wavelength conversion layer 4 is covered by the cut filter 5 is preferable.

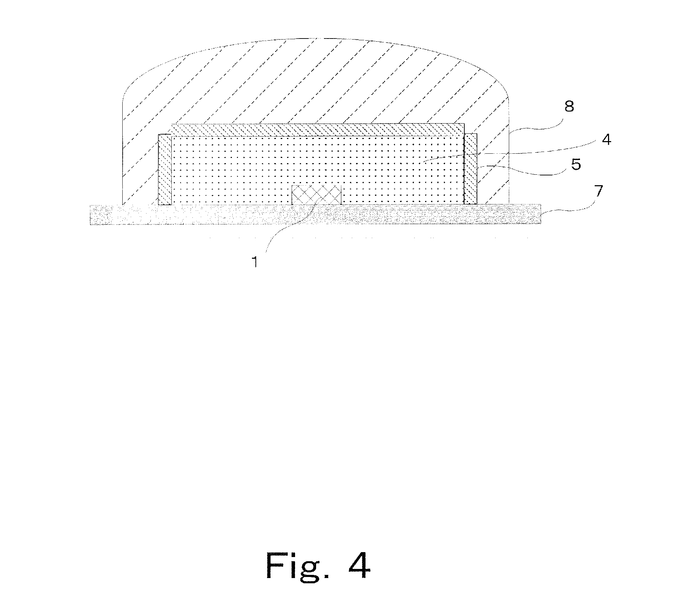

Fig. 4 is a semiconductor light emitting device with a lens. A lens 8 having a convex shape is arranged on the light emission side of the cut filter 5. By forming the convex lens 8, it is possible to condense emitted light.

Note that it is possible to appropriately set the number, the positions, the size, the optical characteristic, or the like of the convex lens 8 according to the light emission characteristic required of the semiconductor light emitting device, the optical characteristic of the transparent substrate 6, the light emission characteristic from the wavelength conversion layer 4 including the phosphor, or the like.

The condensing lens is not limited to the convex lens 8 and may be formed by the surface treatment of the transparent substrate 6 or a member may be separately provided. Examples of the application of the surface treatment for condensing light emitted to the outside include Fresnel lenses and fly-eye lenses.

Although not shown in the figure, the Fresnel lenses can be formed, for example, in positions opposed to cavities formed on the surface of the transparent substrate 6. Note that it is possible to appropriately set the number, the positions, the size, the optical characteristic, or the like of the Fresnel lenses according to the light emission characteristic required of the semiconductor light emitting device, the optical characteristic of the transparent substrate 6, the light emission characteristic from the wavelength conversion layer 4 including the phosphor, or the like.

Concerning the fly-eye lenses, it is possible to appropriately set the number, the positions, the size, or the like of semispherical projections formed by the fly-eye lenses according to the light emission characteristic required of the semiconductor light emitting device, the optical characteristic of the transparent substrate 6, the light emission characteristic from the wavelength conversion layer 4 including the phosphor, or the like. Further, it is also possible to vary the respective semispherical projections without setting the semispherical projections the same. It is also possible to appropriately set a distribution of the different semispherical projections according to the light emission characteristic required of the semiconductor light emitting device, the optical characteristic of the transparent substrate 6, the light emission characteristic from the phosphor layer, or the like.

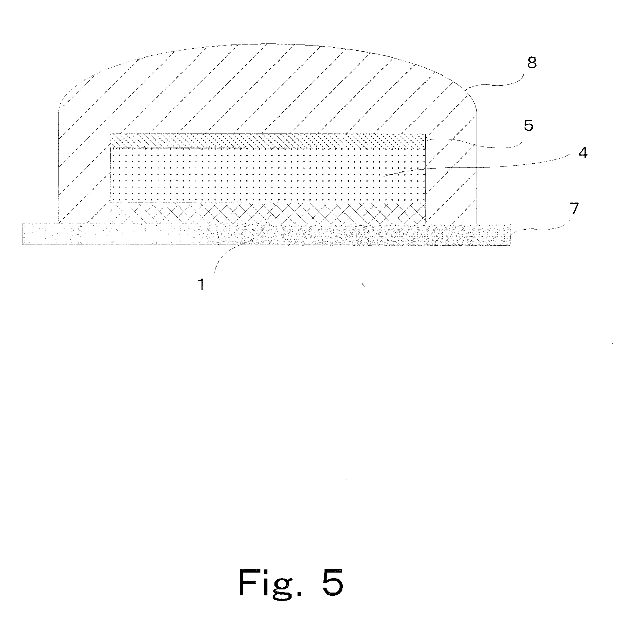

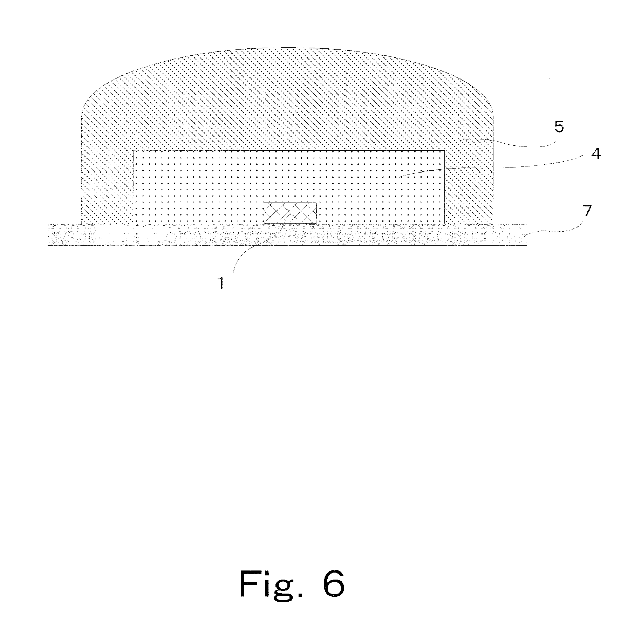

Fig. 5 to Fig. 8 arc modifications of Fig. 4. Fig. 5 is a semiconductor light emitting device in which a semiconductor light emitting element having a large light emission area is used as the semiconductor light emitting element 1. Fig. 6 to Fig. 8 are forms in which a lens employing a cut filter function is used as the lens 8. By using such a lens, it is possible to simplify the configuration of the semiconductor light emitting device.

An overall diagram of a semiconductor light emitting device in which a wavelength conversion layer is a light reflection type wavelength conversion layer among the semiconductor light emitting devices including the cut filters of the present invention is shown in Fig. 9.

In Fig. 9, the semiconductor light emitting device emits light upward in the figure. The semiconductor light emitting element 1 is supported by the columnar supporting body 7 and emits light toward the wavelength conversion layer 4. The light of the semiconductor light emitting element 1 emitted toward the wavelength conversion layer 4 passes through the wavelength conversion layer 4 and is then reflected by a reflecting section of a housing 9. The traveling direction of the light changes. The light is emitted from the semiconductor light emitting device through the cut filter 5. The housing 9 is not particularly limited as long as the housing 9 includes an opening section and a reflecting section. A portion other than the opening section is preferably manufactured by a material capable of reflecting light. Since the columnar supporting body is formed of a heat radiation member, it is possible to efficiently emit heat generated in the semiconductor light emitting element by transferring the heat to the housing through the supporting body. The reflecting section is preferably has a shape of a paraboloid of revolution. Consequently, lights subjected to wavelength conversion can be mixed well and emitted from the light emitting device.

Since a housing 9 includes a plurality of fins 10, it is possible to allow heat generated in the wavelength conversion to escape and prevent deterioration of the wavelength conversion layer 4.

[Experiments]

Experiment examples indicating a relation between transmission of excitation light and light emission intensity performed by the inventors are explained below.

[Experiment 1]

A violet LED (having a light emission peak wavelength of 407 nm to 410 nm) was used as an excitation source and a layer in which a phosphor was uniformly dispersed and retained in binder resin (silicone resin; U113D manufactured by Mitsubishi Chemical Corporation) was used as a wavelength conversion layer. A semiconductor light emitting device in which the violet LED and the wavelength conversion layer were arranged at a distance of 0.5 mm was manufactured. As phosphors included in the wavelength conversion layer, a BAM phosphor represented by a composition formula (Ba, Sr)$MgAl_{10}O_{17}$:Eu was mixed as a blue phosphor, a BSS phosphor represented by a composition formula (Ba, Sr)$_2SiO_4$:Eu was mixed as a green phosphor, and a CASON phosphor represented by $CaAlSiO_xN_{3-x}$: Eu, was mixed as a red phosphor at a ratio at which excitation light transmittance changes. In all cases, a correlated color temperature of light emitted from the semiconductor light emitting device was set to be 2700 K. Mixing ratios of the phosphors and the resin and the excitation light transmittance are shown in Table 1.

[Table 1]

Table 1

| Excitation light transmittance | 226% | 146% | 98% | 75% | 52% | 20% | 8% |
|---|---|---|---|---|---|---|---|
| Binder content (weight %) | 88.3% | 84.8% | 80.8% | 76.9% | 73.7% | 57.2% | 64.2% |
| BAM (weight %) | 1.9% | 5.0% | 8.6% | 12.1% | 15.6% | 34.1% | 26.1% |
| BSS (weight %) | 2.1% | 2.3% | 2.5% | 2.6% | 2.7% | 2.7% | 2.7% |
| CASON (weight %) | 7.7% | 7.9% | 8.1% | 8.3% | 8.0% | 6.0% | 7.1% |

Note that the excitation light transmittance means light emission peak intensity deriving from the semiconductor light emitting element when maximum light emission peak intensity deriving from the phosphor is set to 100% in a spectrum of light emitted by the semiconductor light emitting device.

Light emission efficiency, conversion efficiency, and a correlated color temperature in the case of respective excitation light transmittances shown in Table 1 are shown in Table 2. A color rendering evaluation index Ra and special color rendering evaluation indexes R9 and R12 are shown in Table 3.

[Table 2]

Table 2

| Excitation light transmittance | light emission efficiency (lm/W) | Conversion efficiency (lm/W) | Correlated color temperature (K) |
|---|---|---|---|
| 226% | 50.3 | 124 | 2704 |
| 146% | 48.3 | 121 | 2709 |
| 98% | 46.8 | 115 | 2689 |
| 75% | 45.0 | 112 | 2705 |
| 52% | 43.4 | 108 | 2700 |
| 20% | 38.0 | 93 | 2707 |
| 8% | 33.2 | 80 | 2704 |

[Table 3]

Table 3

| Excitation light transmittance | Ra | R9 | R12 |
|---|---|---|---|
| 226% | 89 | 67 | 55 |
| 146% | 92 | 72 | 71 |
| 98% | 94 | 77 | 82 |
| 75% | 96 | 80 | 87 |
| 52% | 97 | 83 | 93 |
| 20% | 97 | 90 | 96 |
| 8% | 96 | 94 | 91 |

As it can be understood from Table 2, when the transmittance of excitation light increases, the light emission efficiency and the conversion efficiency are improved. Conventionally, excitation lights from a violet LED, a near ultraviolet LED, and an ultraviolet LED are considered to be preferably reused as excitation lights without being emitted from the semiconductor light emitting device rather than as components of white light. However, the above result is a result that denies such a conventional idea.

The present inventors assume the reason for this as follows.

In order to reduce the excitation light transmittance, it is necessary to densely fill the phosphor. However, it is considered that, when the phosphor is densely filled, fluorescent light from the phosphor further collides with the phosphor and a light absorption loss occurs while the collision of the light is repeated.

On the other hand, from Table 3, when the transmittance of the excitation light increases, a color rendering property is deteriorated. The inventors consider that a cause of this is that, when a large amount of violet light, which is excitation light, is transmitted, the intensity of the violet excitation light increases and affects chromaticity and that, in order to adjust emitted light to be white light, the content of the blue phosphor has to be reduced and light emission intensity of the blue phosphor decreases. Therefore, if light transmitted through the wavelength conversion layer can be cut, it is possible to improve the light emission intensity of the blue phosphor and prevent the deterioration in the color rendering property. That is, the semiconductor light emitting device including the cut filter of the present invention can attain both of high light emission efficiency and a high color rendering property.

[Experiment 2]

Types of phosphors in use were changed and an experiment 2 was performed.

A violet LED (having a light emission peak wavelength of 407 nm to 410 nm) was used as an excitation source and a layer in which a phosphor was uniformly dispersed and retained in binder resin (silicone resin; U113D manufactured by Mitsubishi Chemical Corporation) was used as a wavelength conversion layer. A semiconductor light emitting device in which the violet LED and the wavelength conversion layer were arranged at a distance of 0.5 mm was manufactured. As phosphors included in the wavelength conversion layer, a SBCA phosphor represented by a composition formula $(Sr, Ba)_{10}(PO_4)_6Cl_2$:Eu was mixed as a blue phosphor, a $\beta$SiAlON phosphor represented by a composition formula $(Si, Al)_6(N, O)_8$:Eu was mixed as a green phosphor, and a CASON phosphor represented by $CaAlSiO_xN_{3-x}$:Eu was mixed as a red phosphor at a ratio at which excitation light transmittance changes. In all cases, a correlated color temperature of light emitted from the semiconductor light emitting device was set to be 2700 K. Mixing ratios of the phosphors and the resin and the excitation light transmittance are shown in Table 4.

[Table 4]

Table 4

| Excitation light transmittance | 175% | 79% | 23% |
|---|---|---|---|
| Binder content (weight %) | 88.0% | 80.0% | 70.0% |
| SBCA (weight %) | 1.5% | 5.7% | 16.0% |
| $\beta$SiAlON (weight %) | 3.7% | 3.8% | 3.5% |

(continued)

| Excitation light transmittance | 175% | 79% | 23% |
|---|---|---|---|
| CASON (weight %) | 8.0% | 9.8% | 10.5% |

Note that the excitation light transmittance means light emission peak intensity deriving from the semiconductor light emitting element when maximum light emission peak intensity deriving from the phosphor is set to 100% in a spectrum of light emitted by the semiconductor light emitting device.

Light emission efficiency, conversion efficiency, and a correlated color temperature in the case of respective excitation light transmittances shown in Table 4 are shown in Table 5. The color rendering evaluation index Ra and the special color rendering evaluation indexes R9 and R12 are shown in Table 6.

[Table 5]

Table 5

| Excitation light transmittance | Light emission efficiency (lm/W) | Conversion efficiency (lm/W) | Correlated color temperature (K) |
|---|---|---|---|
| 175% | 52.1 | 141 | 2702 |
| 79% | 50.7 | 138 | 2712 |
| 23% | 46.1 | 124 | 2685 |

[Table 6]

Table 6

| Excitation light transmittance | Ra | R9 | R12 |
|---|---|---|---|
| 175% | 83 | 58 | 48 |
| 79% | 93 | 76 | 81 |
| 23% | 97 | 91 | 95 |

As it can be understood from Tables 5 and 6, a result same as the result of the experiment 1 was obtained in the experiment 2 in which the types of the phosphors were changed.

[Experiment 3]

An experiment 3 was performed to find how the color rendering property of the semiconductor light emitting device was affected by changing a type (a cut wavelength) of the cut filter included in the semiconductor light emitting device. A semiconductor light emitting element having a wavelength of 410 nm was used as an excitation source and phosphors were adjusted to set a correlated color temperature to 2700 K. A semiconductor light emitting device not including a cut filter was manufactured. Concerning semiconductor light emitting devices respectively including light absorption type cut filters configured to cut wavelengths equal to or less than 400 nm, equal to or less than 410 nm, equal to or less than 420 nm, equal to or less than 430 nm, and equal to or less than 440 nm, phosphors were adjusted to set a correlated color temperature to 2700 K. The color rendering evaluation index Ra and the special color rendering evaluation indexes R9 and R12 of lights emitted by the phosphors are shown in Table 7.

[Table 7]

Table 7

| Cut wavelength region | CCT (K) | Excitation light transmittance (%) | Light emission peak intensity deriving fromemitted light of light emitting element with respect to maximum intensity of light emission spectrum (%) | Color rendering evaluation index | | |
|---|---|---|---|---|---|---|
| | | | | Ra | R9 | R12 |
| No cut | 2700 | 100 | 100 | 87 | 83 | 59 |

(continued)

| Cut wavelength region | CCT (K) | Excitation light transmittance (%) | Light emission peak intensity deriving fromemitted light of light emitting element with respect to maximum intensity of light emission spectrum (%) | Color rendering evaluation index | | |
|---|---|---|---|---|---|---|
| | | | | Ra | R9 | R12 |
| 400 nm or less | 2700 | 100 | 10 | 87 | 84 | 60 |
| 410 nm or less | 2700 | 100 | 84 | 89 | 86 | 67 |
| 420 nm or less | 2700 | 100 | 38 | 93 | 92 | 80 |
| 430 nm or less | 2700 | 100 | 0.2 | 98 | 98 | 86 |
| 440 nm or less | 2700 | 100 | 0.2 | 96 | 96 | 84 |

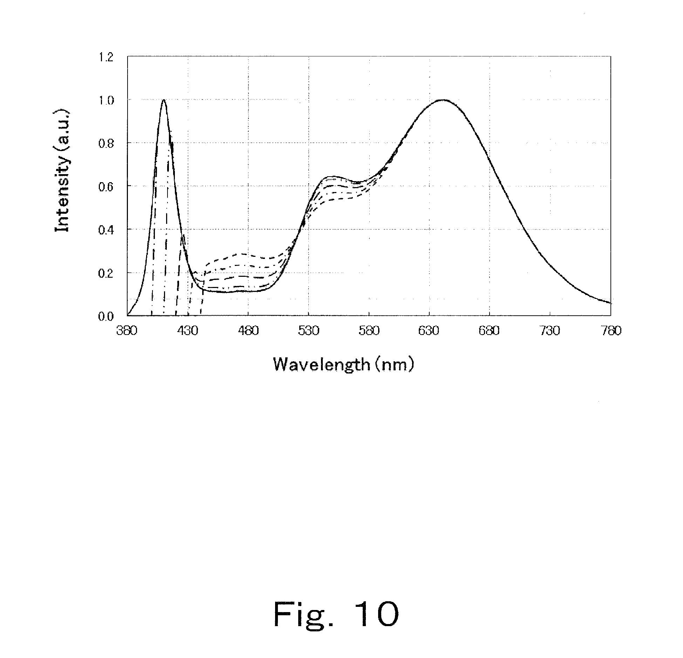

A spectrum of light emitted by the semiconductor light emitting devices respectively including the cut filters configured to cut wavelengths equal to or less than 400 nm, equal to or less than 410 nm, equal to or less than 420 nm, equal to or less than 430 nm, and equal to or less than 440 nm are shown in Fig. 10. From Table 7 and Fig. 10, the excitation light transmittances of the lights emitted from the semiconductor light emitting devices are as high as 100%. It is estimated from the result of the experiment 1 that the semiconductor light emitting devices having high light emission efficiency can be attained.

From these results, it is possible to improve the light emissionefficiency byadjustingthe excitation light transmittances in the semiconductor light emitting devices and it is possible to improve the color rendering property by cutting transmitted excitation light.

Examples

<Example 1 and Reference examples 1 to 3>

An experiment was performed to find how the light emission efficiency and the color rendering property of the semiconductor light emitting device were affected by changing a type (a cut method) of the cut filter included in the semiconductor light emitting device. A semiconductor light emitting element having a wavelength of 410 nm was used as an excitation source and semiconductor light emitting devices not including cut filters were manufactured as reference examples 1 to 3. A light absorption type cut filter (CLAREX N-113 manufactured by Nitto Jushi Kogyo Co., Ltd.) configured to cut a wavelength equal to or less than 420 nm was used and a semiconductor light emitting device was manufactured as an example 1. Note that the excitation light transmittance of the semiconductor light emitting device according to the example 1 not including a cut filter is 100%.

Excitation light transmittances, light emission efficiencies, conversion efficiencies, correlated color temperatures, and damage coefficients in the example 1 and the reference examples 1 to 3 are shown in Table 8. The color rendering evaluation index Ra and the special color rendering evaluation indexes R9 and R12 are shown in Table 9.

[Table 8]

Table 8

| | Excitation light transmittance | Light emission efficiency (lm/W) | Conversion efficiency (lm/W) | Correlated color temperature (K) | Damage coefficient |
|---|---|---|---|---|---|
| Reference Example 1 | 23% | 44.6 | 130 | 2685 | 0.011 |
| Reference Example 2 | 79% | 47.1 | 145 | 2712 | 0.026 |
| Reference Example 3 | 175% | 50.5 | 148 | 2702 | 0.047 |

(continued)

|  | Excitation light transmittance | Light emission efficiency (lm/W) | Conversion efficiency (lm/W) | Correlated color temperature (K) | Damage coefficient |
|---|---|---|---|---|---|
| Example 1 | 1% | 46.9 | 141 | 2585 | 0.009 |

[Table 9]

Table 9

|  | Excitation light transmittance | Ra | R9 | R12 |
|---|---|---|---|---|
| Reference Example 1 | 23% | 97 | 91 | 95 |
| Reference Example 2 | 79% | 93 | 76 | 81 |
| Reference Example 3 | 175% | 83 | 58 | 48 |
| Example 1 | 1% | 95 | 77 | 90 |

As it can be understood from Tables 8 and 9, when the light absorption type cut filter configured to cut a wavelength equal to or less than 420 nm is used, with the excitation light transmittance being suppressed, the light emission efficiency is slightly deteriorated, but high light emission efficiency is still shown and a high color rendering property is maintained. Further, it is possible to sufficiently reduce the damage coefficient.

<Comparative example 1 and Reference example 4>

As in the reference examples 1 to 3, a semiconductor light emitting device not including a cut filter was manufactured as a reference example 4. A dielectric mirror for 0° to 45° incidence (TFVM-15C03-405 manufactured by Sigma Koki Co., Ltd.) was used as a light reflection type cut filter and a semiconductor light emitting device was manufactured as a comparative example 1.
Excitation light transmittances, light emission efficiencies, correlated color temperatures, and damage coefficients in the comparative example 1 and the reference example 4 are shown in Table 10. The color rendering evaluation index Ra and the special color rendering evaluation indexes R9 and R12 are shown in Table 11.
[Table 10]

Table 10

|  | Excitation light transmittance | Light emission efficiency (lm/W) | Correlated color temperature (K) | Damage coefficient |
|---|---|---|---|---|
| Reference Example 4 | 91% | 49.9 | 2676 | 0.031 |
| Comparative Example 1 | 6% | 47.6 | 2472 | 0.004 |

[Table 11]

Table 11

|  | Excitation light transmittance | Ra | H9 | R12 |
|---|---|---|---|---|
| Reference Example 4 | 91% | 95 | 82 | 82 |
| Comparative Example 1 | 76% | 93 | 70 | 81 |

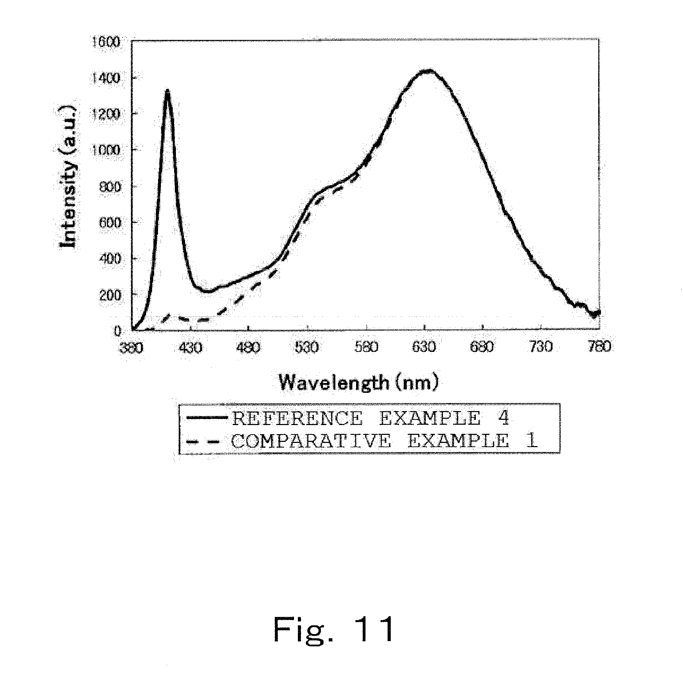

Spectra of lights emitted by the respective semiconductor light emitting devices are shown in Fig. 11. As it can be understood from Tables 10 and 11 and Fig. 11, when the excitation light transmittance is reduced using the light reflection type cut filter, the light emission efficiency and the color rendering property are substantially deteriorated.

<Comparative example 2 and Reference example 5>

As in the reference examples 1 to 3, a semiconductor light emitting device not including a cut filter was manufactured as a reference example 5. A light interference type cut filter (YIF-BA420IFS manufactured by Sigma Koki Co., Ltd.) was used and a semiconductor light emitting device was manufactured as a comparative example 2.

Excitation light transmittances, light emission efficiencies, correlated color temperatures, and damage coefficients in the comparative example 2 and the reference example 5 are shown in Table 12. The color rendering evaluation index Ra and the special color rendering evaluation indexes R9 and R12 are shown in Table 13.

[Table 12]

Table 12

| | Excitation light transmittance | Light emission efficiency (lm/W) | Correlated color temperature (K) | Damage coefficient |
|---|---|---|---|---|
| Reference Example 5 | 0.91 | 49.7 | 2684 | 0.030 |
| Comparative Example 2 | 0.76 | 47.7 | 2651 | 0.025 |

[Table 13]

Table 13

| | Excitation light transmittance | Ra | R9 | R12 |
|---|---|---|---|---|
| Reference Example 5 | 0.91 | 95 | 81 | 82 |
| Comparative Example 2 | 0.76 | 95 | 81 | 83 |

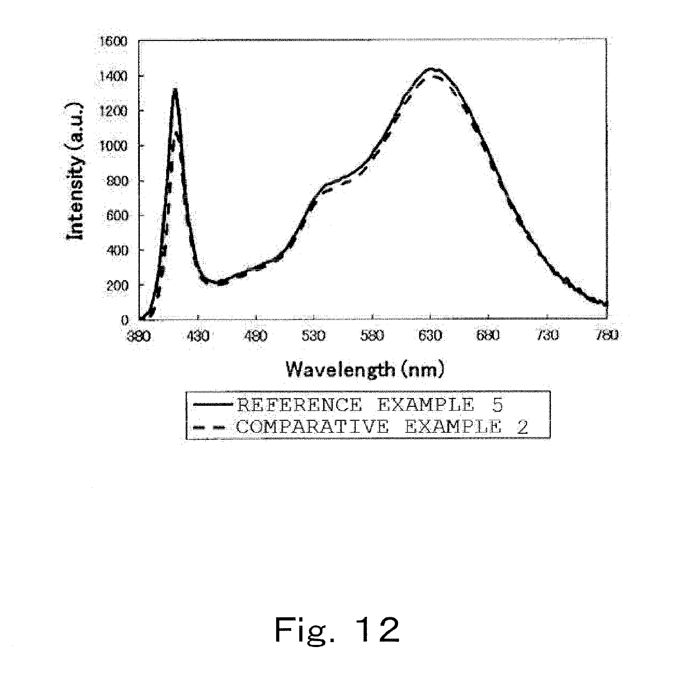

Spectra of lights emitted by the respective semiconductor light emitting devices are shown in Fig. 12. As it can be understood from Tables 12 and 13 and Fig. 12, when the excitation light transmittance is reduced using the light interference type cut filter, although there is no large change in the color rendering property, the light emission efficiency is substantially deteriorated. It is evident that the damage coefficient cannot be sufficiently reduced.

INDUSTRIAL APPLICABILITY

According to the present invention, it is possible to provide a semiconductor light emitting device that attains both of high light emission efficiency and a high color rendering property. The semiconductor light emitting device of the present invention is effective as a light source for general lighting. Since the semiconductor light emitting device is a light source having high light emission efficiency, the semiconductor light emitting device can be applied not only to the general lighting but also to various kinds of lighting.

While the invention has been described in detail and with reference to specific embodiments thereof, it will be apparent to one skilled in the art that various changes and modifications can be made therein without departing from the spirit and scope thereof.

EXPLANATION OF REFERENCE NUMERALS

1. Semiconductor light emitting element
2. Bonding wire
3. Package
4. Wavelength conversion layer
5. Cut filter
6. Transparent substrate
7. Support
8. Lens
9. Housing

10. Fin

**Claims**

1. A semiconductor light emitting device comprising:

   a semiconductor light emitting element configured to emit light having a light emission peak at a wavelength 390 nm or more and 430 nm or less; and
   a wavelength conversion layer including a phosphor configured to emit light using, as an excitation source, the light emitted by the semiconductor light emitting element,
   the semiconductor light emitting device including a cut filter configured to absorb light having a short wavelength equal to or less than 430 nm and transmit light having a long wavelength greater than 430 nm, and emitting light through the cut filter, wherein
   in a spectrum of the light emitted by the semiconductor light emitting device, light emission peak intensity deriving from the emitted light of the semiconductor light emitting element with respect to maximum intensity of the spectrum is equal to or lower than 50%.

2. A semiconductor light emitting device comprising:

   a semiconductor light emitting element configured to emit light having a light emission peak at a wavelength 390 nm or more and 430 nm or less; and
   a wavelength conversion layer including a phosphor configured to emit light using, as an excitation source, the light emitted by the semiconductor light emitting element,
   the semiconductor light emitting device including a cut filter configured to absorb light having a short wavelength equal to or less than 430 nm and transmit light having a long wavelength greater than 430 nm, and emitting light through the cut filter, wherein
   the wavelength conversion layer contains at least one narrowband phosphor among phosphors of a group of a narrowband red phosphor, a narrowband green phosphor, and a narrowband blue phosphor, and
   in a spectrum of the light emitted by the semiconductor light emitting device, light emission peak intensity deriving from the emitted light of the semiconductor light emitting element with respect to maximum intensity of the spectrum is equal to or lower than 20%.

3. The semiconductor light emitting device according to claim 1 or 2, wherein the wavelength conversion layer is a light transmission type wavelength conversion layer, and the cut filter is arranged on an emission side of light of the wavelength conversion layer.

4. The semiconductor light emitting device according to claim 1 or 2, wherein
   the semiconductor light emitting device includes a housing including an opening section capable of emitting light and a reflecting section configured to reflect light,
   the cut filter is arranged in the opening section of the housing, and
   the wavelength conversion layer is a light reflection type wavelength conversion layer arranged in the reflecting section of the housing to reflect light emitted from the semiconductor light emitting element.

5. The semiconductor light emitting device according to any one of claims 1 to 4, wherein the cut filter absorbs 50% or more of light having a wavelength equal to or less than 430 nm.

6. The semiconductor light emitting device according to any one of claims 1 to 5, wherein, when an incident angle $\theta$ is changed to an arbitrary angle in a range of 0 to 180°, fluctuation $\Delta t\theta$ of transmittance $t\theta$ of light made incident on a cut filter surface at the incident angle $\theta$ is equal to or lower than 50%.

7. The semiconductor light emitting device according to any one of claims 1 to 6, wherein the semiconductor light emitting device includes a transparent substrate and the cut filter is supported by the transparent substrate.

8. The semiconductor light emitting device according to claim 7, wherein a surface of the transparent substrate on a side opposed to the cut filter is subjected to non-reflection treatment.

9. The semiconductor light emitting device according to any one of claims 1 to 5, wherein a light emission peak wavelength of light emitted from the semiconductor light emitting element and reaching the cut filter without being subjected to wavelength conversion by the wavelength conversion layer is 50% or more and 250% or less of light emission intensity of light at a maximum light emission peak of visible light emitted from the semiconductor light emitting device.

10. The semiconductor light emitting device according to any one of claims 1 to 9, wherein the semiconductor light emitting element and the wavelength conversion layer are arranged to have a distance 1 mm or more and 500 mm or less.

11. The semiconductor light emitting device according to any one of claims 1 to 9, wherein the semiconductor light emitting element and the wavelength conversion layer are arranged in contact with each other.

12. The semiconductor light emitting device according to any one of claims 1 to 11, wherein the semiconductor light emitting device emits white light having a correlated color temperature 1800 K or more and 7500 K or less.

13. The semiconductor light emitting device according to any one of claims 1 to 12, wherein an average color rendering index Ra is equal to or higher than 70.

14. An illumination device comprising the semiconductor light emitting device according to any one of claims 1 to 13.

(a)

(b)

# Fig. 1

(a)

(b)

Fig. 2

(a)

(b)

Fig. 3

Fig. 4

Fig. 5

Fig. 6

Fig. 7

# Fig. 8

Fig. 9

Fig. 10

Fig. 11

Fig. 12

<table>
<tr><td colspan="2" align="center">**INTERNATIONAL SEARCH REPORT**</td><td>International application No.<br>PCT/JP2013/059611</td></tr>
</table>

**A.   CLASSIFICATION OF SUBJECT MATTER**
*H01L33/50*(2010.01)i, *F21V9/08*(2006.01)i, *F21Y101/02*(2006.01)n

According to International Patent Classification (IPC) or to both national classification and IPC

**B.   FIELDS SEARCHED**

Minimum documentation searched (classification system followed by classification symbols)
H01L33/00-33/64, F21V9/08, F21Y101/02

Documentation searched other than minimum documentation to the extent that such documents are included in the fields searched
Jitsuyo Shinan Koho          1922-1996   Jitsuyo Shinan Toroku Koho    1996-2013
Kokai Jitsuyo Shinan Koho    1971-2013   Toroku Jitsuyo Shinan Koho    1994-2013

Electronic data base consulted during the international search (name of data base and, where practicable, search terms used)

**C.   DOCUMENTS CONSIDERED TO BE RELEVANT**

| Category* | Citation of document, with indication, where appropriate, of the relevant passages | Relevant to claim No. |
|---|---|---|
| X<br>Y | JP 2009-99759 A   (Fine Rubber Laboratories Co.,<br>Ltd.),<br>07 May 2009 (07.05.2009),<br>paragraphs [0024] to [0025], [0028]; fig. 3<br>(Family: none) | 1,3,5,6,9,14<br>2,4,7,8,<br>10-13 |
| Y | JP 2011-178960 A  (Toshiba Corp.),<br>15 September 2011 (15.09.2011),<br>paragraphs [0029], [0043], [0053], [0059],<br>[0070], [0110]; fig. 1, 2<br>& US 2011/0215709 A1 | 2,11-13 |
| Y | JP 2004-128393 A  (Sharp Corp.),<br>22 April 2004 (22.04.2004),<br>paragraph [0044]; fig. 9<br>& US 2004/0066140 A1     & CN 1497742 A | 4 |

| ☒ | Further documents are listed in the continuation of Box C. | ☐ | See patent family annex. |
|---|---|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>    05 June, 2013 (05.06.13) | Date of mailing of the international search report<br>    18 June, 2013 (18.06.13) |
|---|---|
| Name and mailing address of the ISA/<br>    Japanese Patent Office | Authorized officer |
| Facsimile No. | Telephone No. |

Form PCT/ISA/210 (second sheet) (July 2009)

<table>
<tr><td colspan="3" align="center"><b>INTERNATIONAL SEARCH REPORT</b></td><td>International application No.<br>PCT/JP2013/059611</td></tr>
</table>

C (Continuation).    DOCUMENTS CONSIDERED TO BE RELEVANT

| Category* | Citation of document, with indication, where appropriate, of the relevant passages | Relevant to claim No. |
|---|---|---|
| Y | JP 2009-272628 A  (Samsung Electronics Co., Ltd.), 19 November 2009 (19.11.2009), paragraph [0071]; fig. 4 & US 2009/0278151 A1    & US 2011/0210367 A1 & DE 102009019909 A1    & KR 10-2009-0116461 A & CN 101577303 A | 7 |
| Y | WO 2010/123059 A1  (CCS Inc.), 28 October 2010 (28.10.2010), paragraphs [0078] to [0079] (Family: none) | 7,8 |
| Y | JP 2011-129901 A  (Mitsubishi Chemical Corp.), 30 June 2011 (30.06.2011), paragraph [0058]; fig. 9 (Family: none) | 10 |

Form PCT/ISA/210 (continuation of second sheet) (July 2009)

**REFERENCES CITED IN THE DESCRIPTION**

**Patent documents cited in the description**

- JP 2007088348 A
- JP 2011228673 A
- JP 3118226 B
- JP 2006008721 A
- JP 2008007751 A
- JP 2007231245 A
- JP 2008038081 A
- WO 2008096300 A
- US 7524437 B
- WO 2007091687 A
- JP 3921545 B
- WO 2007088966 A
- JP 2008274254 A
- WO 2009072043 A
- WO 2007105631 A